(19) **Europäisches Patentamt** / **European Patent Office** / **Office européen des brevets**

(11) **EP 3 696 925 A1**

(12) **EUROPEAN PATENT APPLICATION**
published in accordance with Art. 153(4) EPC

(43) Date of publication:
**19.08.2020 Bulletin 2020/34**

(21) Application number: **19872768.7**

(22) Date of filing: **27.09.2019**

(51) Int Cl.:
**H01S 5/14** (2006.01)          **H01S 3/082** (2006.01)

(86) International application number:
**PCT/CN2019/108481**

(87) International publication number:
**WO 2020/078197 (23.04.2020 Gazette 2020/17)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.10.2018 CN 201811197771**

(71) Applicant: **Technical Institute of Physics and Chemistry, Chinese Academy of Sciences Beijing 100190 (CN)**

(72) Inventors:
• **WANG, Xiaojun**
  **Beijing 100190 (CN)**
• **ZONG, Nan**
  **Beijing 100190 (CN)**
• **PENG, Qinjun**
  **Beijing 100190 (CN)**
• **XU, Zuyan**
  **Beijing 100190 (CN)**
• **YANG, Jing**
  **Beijing 100190 (CN)**

(74) Representative: **Huang, Liwei**
  **Cäcilienstraße 12**
  **40597 Düsseldorf (DE)**

(54) **SEMICONDUCTOR LASER**

(57)     Disclosed in the present invention is a semiconductor laser, which includes one or more semiconductor chips (1-1), a total length of a gain region (1-11A) of a light-emitting unit (1-11) of each of the semiconductor chips (1-1) in a slow axis direction being 1 mm-10 cm; a laser resonant cavity configured to adjust semiconductor laser emitted by the light-emitting unit (1-11) to resonate in the slow axis direction, so that the size of the gain region (1-11A) of the light-emitting unit (1-11) in the slow axis direction matches a fundamental mode spot radius $\omega_0$; and a fast-axis collimating element (FAC) disposed in the laser resonant cavity and configured to collimate the laser emitted by the light-emitting unit (1-11) in a fast axis direction. The semiconductor laser according to an embodiment of the present invention can improve the high-power output capability of the gain region on the one hand, and improve the beam quality on the other hand, which can achieve a high beam quality output of $M^2 < 2$.

**FIG. 2a**

EP 3 696 925 A1

## Description

### TECHNICAL FIELD

The present invention relates to the technical field of laser devices, and in particular to a semiconductor laser.

### BACKGROUND

A semiconductor laser uses a semiconductor material as a gain medium, uses electrons to emit light through transit between energy levels, and uses parallel mirrors formed by cleavage planes of semiconductor crystals to form a resonant cavity. Optical oscillation feedback is formed under electrical injection, which generates radiation amplification of light and achieves laser output. It is the laser with the highest conversion efficiency (electro-optical conversion efficiency up to 70%), the widest wavelength range, the strongest adaptability and reliability, and the lowest batch production cost. However, due to the small size of the resonant cavity of the semiconductor laser (usually millimeter-level cavity length and micron-level cavity surface), the high power density in the laser resonant cavity and the light exit port (on the order of MW/cm$^2$), and the extremely short gain medium region and other limitations, the output power of a single semiconductor light-emitting unit is relatively small, and it is difficult to directly output power of one hundred watts or more. The beam quality of the existing semiconductor laser in the slow axis direction is poor (for example, the beam quality of the 10W-class 100um wide semiconductor laser unit in the slow axis is $M^2$ - 10), so how to obtain semiconductor laser output with high power, high beam quality, and high power density has become a major bottleneck technology in the international laser field.

In terms of unit technology, the currently used high-power semiconductor laser devices are mainly edge emitting structure devices whose light emission direction is parallel to the epitaxial layer. According to the number of units integrated on a single chip, it can be divided into single laser tubes (light-emitting units) and line arrays (bar). A single laser tube is a single laser unit, which can achieve a power output of several watts to tens of watts. The light-emitting area in the x direction of the single laser tube is tens to hundreds of microns, and the divergence angle thereof is generally 6 ° - 15 °, which is called the slow axis direction. The light-emitting area in the y direction of the single laser tube is only 1 - 5$\mu$m, and the divergence angle thereof is as high as 20 ° - 55 °, which is called the fast axis direction. The laser line array is formed by integrating a plurality of laser units in the x direction and can output hundreds of watts of power. The width of a line array is generally 10 mm, the fill factor for CW operation is generally 20 - 30%, and the fill factor for QCW operation is generally 50 - 80%. In principle, the beam quality of a line array cannot be improved, and its beam quality will be inferior to that of a single laser tube.

In terms of integrated technology, laser beam combining is to combine a plurality of single laser tubes into one beam, which is an effective means to increase power, including spatial beam combining, sequential beam combining, polarization beam combining, and spectral beam combining. Semiconductor array is the earliest beam combining method, which is obtained by performing spatial beam combining on a plurality of semiconductor line arrays and superimposes them in the fast axis direction. Although the power above kW can be obtained, the deterioration of beam quality is more serious, and the beam quality is worse than that of a single line array and single laser tube. In 1999, Tso Yee Fan et al. at the Massachusetts Institute of Technology's Lincoln Laboratory first proposed the method of spectrally beam-combining a semiconductor laser array with a grating external cavity method. This method has received great attention and attention. It can make the beam quality of the bar in the slow axis direction after beam combining equal to that of a single laser tube. However, spectral beam combining still cannot improve the laser beam quality of a single laser tube.

### SUMMARY

An object of the present invention is to provide a semiconductor laser. A total length of a gain region of a semiconductor laser gain region module in a slow axis direction is set to 1 mm-10 cm. A laser resonant cavity is provided to adjust semiconductor laser emitted by a light-emitting unit to resonate in the slow axial direction, so that the size of the gain region of the light-emitting unit in the slow axis direction matches a fundamental mode spot radius $\omega_0$, which on the one hand can improve the high-power output capability of the gain region, and on the other hand can improve the beam quality.

In order to solve the above problem, an embodiment of the present invention provides a semiconductor laser, including: one or more semiconductor chips, a total length of a gain region of a light-emitting unit of each of the semiconductor chips in a slow axis direction being 1 mm-10 cm; a laser resonant cavity configured to adjust semiconductor laser emitted by the light-emitting unit to resonate, so that the size of the gain region of the light-emitting unit in the slow axis direction matches a fundamental mode spot radius $\omega_0$; and a fast-axis collimating element disposed in the laser resonant cavity and configured to collimate the laser emitted by the light-emitting unit in a fast axis direction.

Further, the size of the gain region of the light-emitting units in the slow axis direction matches the fundamental

mode spot radius $\omega_0$ such that: a ratio of a length of laser emitted by a single light-emitting unit in the slow axis direction to a projection value of a fundamental mode spot diameter $2\omega_0$ in the slow axis direction of the gain region is 1-4.

Further, a fast-axis collimating element is disposed at a distance $f_{FAC}$ from a front end surface of the light-emitting unit. The laser emitted by the light-emitting unit has a focal length of $f_{FAC}$ in the fast axis direction of the gain region and a focal length of $\infty$ in the slow axis direction of the gain region.

Further, the fast-axis collimating element is a short-focal-length cylindrical lens with a focal length of 0.3-1.5 mm in the fast axis direction.

Further, a ridge width of the light-emitting unit of the semiconductor chip is 1-2 mm; and the laser resonant cavity is a stable cavity in the slow axis direction.

Further, the laser resonant cavity includes a first cavity mirror and a first output coupling mirror; and the first cavity mirror is configured to reflect laser incident on a surface thereof to the semiconductor chip for being output through the first output coupling mirror.

Further, the first cavity mirror is a concave mirror with a concave surface facing the light-emitting unit.

Further, the semiconductor chip includes M light-emitting units, $M \geq 2$, and the M light-emitting units are connected in series in the slow axis direction. Further, the M light-emitting units are arranged at equal intervals.

Further, the laser resonant cavity further includes a roof prism, which is disposed in front of the fast-axis collimating element, and is configured to reflect the laser in the laser resonant cavity to the gain region for being output through the first output coupling mirror.

Further, there are M-1 roof prisms.

Further, the concave surface of the first cavity mirror is plated with a film having a high reflectivity for output laser wavelength, and the first output coupling mirror is plated with a partially transmissive film for the output laser wavelength with a transmittance higher than 40%; the front end surface of the semiconductor chip is plated with a film having a high transmittance for the output laser wavelength, and the rear end face thereof is plated with a film having a high reflectivity for the output laser wavelength, and a light transmitting surface of the fast-axis collimating element is plated with a film having a high transmittance for the output laser.

Further, a ridge width of the light-emitting unit of the semiconductor chip is 2-5 mm; and the laser resonant cavity is an unstable cavity in the slow axis direction.

Further, the laser resonant cavity includes a second cavity mirror, a third cavity mirror, and a second output coupling mirror; the second cavity mirror is configured to reflect laser incident on a surface thereof to the semiconductor chip; the second output coupling mirror, disposed with a hole in the center thereof, reflects and outputs laser incident on a surface thereof; and the laser emitted by the light-emitting unit passes through the central hole of the second output coupling mirror and focuses in vicinity of the central hole of the second output coupling mirror to form a focal point after being reflected by the third cavity mirror; and the third cavity mirror is configured to reflect the laser passing through the hole to the semiconductor chip.

Further, the second cavity mirror is a concave mirror with a concave surface facing the light-emitting unit, and is disposed in front of the fast-axis collimating element (FAC); the third cavity mirror is disposed in front of the fast-axis collimating element and has a certain angle $\alpha$ with an optical path in the laser resonant cavity; and the third cavity mirror is a concave mirror, and is disposed in front of the second output coupling mirror.

Further, there are M light-emitting units, $M \geq 2$, and the M light-emitting units are connected in series in the slow axis direction.

Further, the M light-emitting units are arranged at equal intervals.

Further, the laser resonant cavity further includes a roof prism, which is disposed in front of the fast-axis collimating element, and is configured to reflect the laser in the laser resonant cavity to the gain region for being output through the second output coupling mirror.

Further, there are M-1 roof prisms.

Further, the concave surfaces of the second cavity mirror and the third cavity mirror are plated with a film having a high reflectivity; the second output coupling mirror is plated with a highly reflective film for a laser angle of $(90-\alpha)$; the front end face of the semiconductor chip is plated with a film with a high transmittance for the output laser wavelength, and the rear end face thereof is plated with a film with a high reflectance for the output laser wavelength, and a light transmitting surface of the fast-axis collimating element is plated with a film having a high transmittance for output laser.

Further, the plurality of semiconductor chips are arranged vertically in the fast axis direction and parallel to each other in the slow axis direction. Further, the plurality of semiconductor chips are arranged at equal intervals.

Further, a ridge width of the light-emitting units of the plurality of semiconductor chips is 1-2 mm; and the laser resonant cavity is a stable cavity in the slow axis direction.

Further, the laser resonant cavity includes a fourth cavity mirror and a third output coupling mirror; and the fourth cavity mirror is configured to reflect laser incident on a surface thereof to the rear end surface of the semiconductor chip for being output through the third output coupling mirror.

Further, the fourth cavity mirror is a concave mirror with a concave surface facing the light-emitting unit.

Further, the semiconductor chip includes M light-emitting units, M ≧ 2, and the M light-emitting units are connected in series in the slow axis direction. Further, the M light-emitting units are arranged at equal intervals.

Further, the laser resonant cavity further includes a roof prism, which is disposed in front of the fast-axis collimating element, and is configured to reflect the laser emitted by the M light-emitting units to the gain region for being output through the third output coupling mirror.

Further, there are M-1 roof prisms.

Further, the concave surface of the fourth cavity mirror is plated with a film having a high reflectivity for output laser wavelength; the third output coupling mirror is plated with a partially transmissive film for the output laser wavelength with a transmittance higher than 40%; the front end surface of the semiconductor chip is plated with a film having a high transmittance for the output laser wavelength, and the rear end face thereof is plated with a film having a high reflectivity for the output laser wavelength, and a light transmitting surface of the fast-axis collimating element is plated with a film having a high transmittance for the output laser.

Further, a ridge width of the light-emitting unit of each semiconductor chip in the plurality of semiconductor chips is 2-5 mm; and the laser resonant cavity is an unstable cavity in the slow axis direction.

Further, the laser resonant cavity includes a fifth cavity mirror, a sixth cavity mirror, and a fourth output coupling mirror; the fifth cavity mirror is configured to reflect laser incident on a surface thereof to the semiconductor chip for being output through the fourth output coupling mirror; the fourth output coupling mirror, disposed with a hole in the center thereof, reflects and outputs laser incident on a surface thereof; and the laser emitted by the light-emitting unit passes through the central hole of the fourth output coupling mirror and focuses in vicinity of the central hole of the fourth output coupling mirror to form a focal point after being reflected by the sixth cavity mirror; and the sixth cavity mirror is configured to reflect the laser passing through the hole to the semiconductor chip.

Further, the fifth cavity mirror is a concave mirror with a concave surface facing the light-emitting unit and is disposed in front of the fast-axis collimating element; the fourth output coupling mirror is disposed in front of the fast-axis collimating element and has a certain angle $\alpha$ with an optical path in the laser resonant cavity; and the sixth cavity mirror is a concave mirror and is disposed in front of the second output coupling mirror.

Further, there are M light-emitting units, M ≧ 2, and the M light-emitting units are connected in series in the slow axis direction.

Further, the M light-emitting units are arranged at equal intervals.

Further, the laser resonant cavity further includes a roof prism, which is disposed in front of the fast-axis collimating element, and is configured to reflect the laser emitted by the M light-emitting units to the gain region for being output through the fourth output coupling mirror.

Further, there are M-1 roof prisms. Further, the M-1 roof prisms are disposed behind the fast-axis collimating element.

Further, the concave surfaces of the fifth cavity mirror and the sixth cavity mirror are plated with a film having a high reflectivity; the fourth output coupling mirror is plated with a highly reflective film for a laser angle of $(90-\alpha)$; the front end surface of the semiconductor chip is plated with a film having a high transmittance for the output laser wavelength, and the rear end surface thereof is plated with a film having a high reflectivity for the output laser wavelength, and a light transmitting surface of the fast-axis collimating element is plated with a film having a high transmittance for output laser.

Further, the laser resonant cavity is further configured to adjust the laser emitted by the plurality of semiconductor chips to perform spectral synthesis in the fast axis direction.

Further, the laser resonant cavity further includes a cylindrical conversion lens and a diffractive optical element; the cylindrical conversion lens is provided with a certain focal length f in the fast axis direction and a focal length of $\infty$ in the slow axis direction; and the gain region and the diffractive optical element are respectively disposed on two focal points of the cylindrical conversion lens.

Further, a heat sink is further included, and the heat sink is disposed below the semiconductor chip and configured to dissipate heat.

The above technical solution of the present invention has the following beneficial technical effects:

(1) For the semiconductor laser according to the embodiment of the present invention, a total length of a gain region of a semiconductor laser gain region module in a slow axis direction is set to 1 mm-10 cm. A laser resonant cavity is provided to adjust semiconductor laser emitted by a light-emitting unit to resonate in the slow axial direction, so that the size of the gain region of the light-emitting unit in the slow axis direction matches a fundamental mode spot radius $\omega_0$, which on the one hand can improve the high-power output capability of the gain region, and on the other hand can improve the beam quality and achieve high beam quality output with $M^2 < 2$.

(2) The semiconductor laser according to the embodiment of the present invention is provided with N chips in the fast axis direction, and the laser emitted by the N chips is spectrally combined in the fast axis direction through the laser resonant cavity, which can improve the output power of the semiconductor laser. Compared with a semiconductor laser with one chip, the output power of a semiconductor laser with N chips can be increased by N times.

## BRIEF DESCRIPTION OF THE DRAWINGS

FIG. 1 is a curve of a fundamental mode spot radius $\omega_0$ of a semiconductor laser according to an embodiment of the present invention as a function of the length Lcav of a laser resonant cavity;
FIG. 2a is a top view of a semiconductor laser according to a first embodiment of the present invention;
FIG. 2b is a side view of the semiconductor laser according to the first embodiment of the present invention;
FIG. 2c is a front view of the semiconductor laser according to the first embodiment of the present invention;
FIG. 3a is a top view of a semiconductor laser according to a second embodiment of the present invention;
FIG. 3b is a side view of a semiconductor laser according to the second embodiment of the present invention;
FIG. 3c is a front view of the semiconductor laser according to the second embodiment of the present invention;
FIG. 4a is a top view of a semiconductor laser according to a third embodiment of the present invention;
FIG. 4b is a side view of the semiconductor laser according to the third embodiment of the present invention;
FIG. 4c is a front view of the semiconductor laser according to the third embodiment of the present invention;
FIG. 4d is a schematic diagram of an oscillation path of laser in the semiconductor laser according to the third embodiment of the present invention;
FIG. 4e is a schematic diagram of a shape of the laser output by the semiconductor laser according to the third embodiment of the present invention;
FIG. 5a is a top view of a semiconductor laser according to a fourth embodiment of the present invention;
FIG. 5b is a schematic diagram of an oscillation path of laser in the semiconductor laser according to the fourth embodiment of the present invention;
FIG. 6a is a top view of a semiconductor laser according to a fifth embodiment of the present invention;
FIG. 6b is a side view of the semiconductor laser according to the fifth embodiment of the present invention;
FIG. 7a is a top view of a semiconductor laser according to a sixth embodiment of the present invention;
FIG. 7b is a side view of the semiconductor laser according to the sixth embodiment of the present invention;
FIG. 8a is a top view of a semiconductor laser according to a seventh embodiment of the present invention;
FIG. 8b is a side view of the semiconductor laser according to the seventh embodiment of the present invention;
FIG. 9a is a top view of a semiconductor laser according to an eighth embodiment of the present invention;
FIG. 9b is a side view of the semiconductor laser according to the eighth embodiment of the present invention.

Reference signs:

1: semiconductor gain module; 1-1: semiconductor chip; 1-11: light-emitting unit; 1-11A: gain region; 1-11A a: laser beam section; 2: first cavity mirror; 3: first output coupling mirror 4: roof prism; 5: second cavity mirror; 6: third cavity mirror; 7: second output coupling mirror; 8: fourth cavity mirror; 9: third output coupling mirror; 10: fifth cavity mirror; 11: sixth cavity mirror; 12: fourth output coupling mirror; 13: heat sink; FAC: fast-axis collimating element; F: cylindrical conversion lens; F': short-focal-length cylindrical conversion lens; DOE: diffractive optical element.

## DETAILED DESCRIPTION

To make the objectives, technical solutions, and advantages of the present invention clearer, the following further describes the present invention in detail with reference to specific embodiments and with reference to the accompanying drawings. It should be understood that these descriptions are merely exemplary and are not intended to limit the scope of the present invention. In addition, in the following description, descriptions of well-known structures and technologies are omitted to avoid unnecessarily obscuring the concept of the present invention.

In the field of semiconductor lasers, technicians generally believe the following points:

The beam quality of the semiconductor laser in the slow axis direction is very poor, $M^2$ is about several tens, and the slow axis length of the gain region corresponding to such a beam quality is in the order of hundreds of um to mm; if the length of the gain region in the slow axis direction is increased, the beam quality will became so bad that the laser produced could not be applied. Therefore, in the field of semiconductor lasers, the length of the gain region in the slow axis direction is up to about 0.5 mm in the range where the beam quality can be used. According to the principle of edge-emitting semiconductors, in general, the wider the ridge of the light-emitting unit, the worse the light beam quality in the slow axis direction. Obviously, in the prior art, while increasing the slow axis length of the gain region, a high beam quality output of $M^2 < 2$ cannot be achieved.

For these reasons, no attempt has been made to increase the size of the gain region in the slow axis direction. It is precisely because of the above-mentioned technical bias that no breakthrough is realized for the structure of the semiconductor laser in the prior art and the beam quality cannot be further improved.

The applicant found in research that in the field of all-solid-state lasers, the size of the pump spot matches the size of the fundamental mode of the resonant cavity, and laser with high beam quality near diffraction limit can be obtained. Therefore, the present application applies this feature of the solid-state laser to the semiconductor laser, which can significantly improve the quality of the laser output by the semiconductor laser.

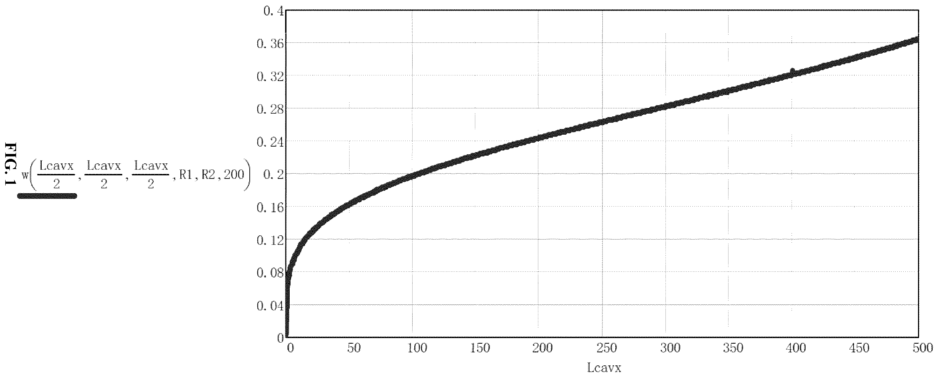

FIG. 1 is a variation curve of a fundamental mode spot radius $\omega_0$ of a semiconductor laser according to an embodiment of the present invention as a function of the length Lcav of a laser resonant cavity.

This application refers to the method for calculating the fundamental mode spot radius in the book "Solid Laser Engineering" by W. Kirchner, and translated by Sun Wen et al. The ABCD matrix method is adopted to calculate the fundamental mode spot of the resonant cavity. Taking the output laser wavelength at 808 nm as an example, a curve of the fundamental mode spot radius $\omega_0$ as a function of the length Lcav of the resonant cavity is obtained (see FIG. 1). It can be concluded that the longer the cavity length Lcav of the laser resonant cavity, the larger the fundamental mode spot radius $\omega_0$ and the better the beam quality.

It can be seen that in the course of research, the applicant found that the root cause of the poor quality of the edge-emitting semiconductor laser's slow-axis beam is that the length (Lcav) of the laser resonant cavity is short, which causes the fundamental mode spot (radius $\omega_0$) to be small, and the size of the light (Lactiv) emitted by the light-emitting unit is much larger than the fundamental mode spot, so the beam quality is poor $\left(M^2 \cdot \sqrt{Lactiv/2\,\omega_0}\right)$. Generally speaking, for a commonly used LD (Laser Diode) chip, that is, a semiconductor laser chip, the length of the laser resonant cavity is the same as the length of the gain region in the z direction.

Therefore, the applicant can draw a conclusion on the basis of research analysis: when the total length of the gain regions of light-emitting units of each semiconductor chip in the slow axis direction is 1 mm-10 cm and the size of the gain region of the light-emitting unit in the slow axis direction is adjusted to match the fundamental mode spot radius $\omega_0$, the quality of the output laser of the semiconductor laser will be good. Specifically, the size of the gain region in the slow axis direction matching the fundamental mode spot radius $\omega_0$ means that the size of the gain region in the slow axis direction is close to the size of the fundamental mode spot radius $\omega_0$.

When the total length of the gain regions of the light-emitting units of each semiconductor chip in the slow axis direction is 1 mm-10 cm, if a ratio of the length of the laser emitted by a single light-emitting unit in the slow axis direction to a fundamental mode spot diameter of the end surface of the gain region (a projection value of the fundamental mode spot diameter in the slow axis direction of the gain region) is 1, and its beam quality $M^2$ is about 1. If a ratio of the length of the laser emitted by a single light-emitting unit in the slow axis direction to the fundamental mode spot diameter of the end surface of the gain region (the projection value of the fundamental mode spot diameter in the slow axis direction of the gain region) is 4, its beam quality $M^2$ is about 2. Therefore, when a ratio of the length of the laser emitted by a single light-emitting unit in the slow axis direction to the projection value of the fundamental mode spot diameter $2\omega_0$ in the slow axis direction of the gain region is 1-4, the beam quality of the semiconductor laser $M^2 < 2$.

Based on the above findings, the present application adopts a solid-state laser design concept to design a semiconductor laser to obtain a semiconductor laser with high power and high beam quality, so that the beam quality in both the fast and slow axes is $M^2 < 2$. Hereinafter, the semiconductor laser according to the present invention will be described in detail in the form of a plurality of embodiments.

In order to clarify the structure of the semiconductor laser in the plurality of embodiments according to the present invention, the following Table 1 gives the coverage of key technical factors in each embodiment of the present invention.

Table 1

| Embodiment | Number of chips (fast axis) | Number of light-emitting units (slow axis) | Cavity type |
|---|---|---|---|
| I (FIG. 2) | Single chip | Single light-emitting region | Stable cavity |
| II (FIG. 3) | Single chip | M light-emitting regions | Stable cavity |
| III (FIG. 4) | Single chip | Single light-emitting region | Unstable cavity |
| IV (FIG. 5) | Single chip | M light-emitting regions | Unstable cavity |
| V (FIG. 6) | N chips | Single light-emitting region | Stable cavity |
| VI (FIG. 7) | N chips | M light-emitting regions | Stable cavity |
| VII (FIG. 8) | N chips | Single light-emitting region | Unstable cavity |
| VIII (FIG. 9) | N chips | M light-emitting regions | Unstable cavity |

Embodiment I

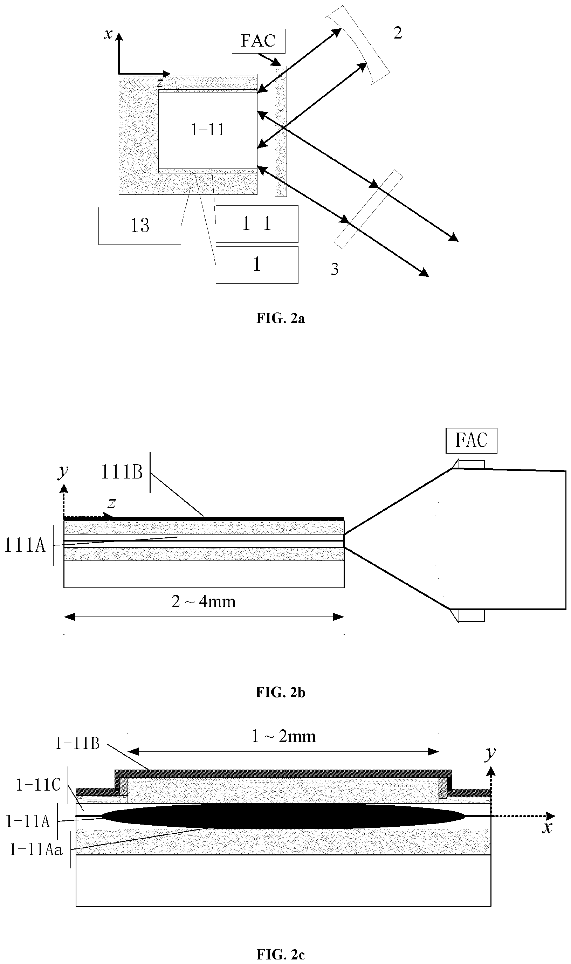

FIG. 2a is a top view of a semiconductor laser according to a first embodiment of the present invention; FIG. 2b is a side view of the semiconductor laser according to the first embodiment of the present invention; and FIG. 2c is a front view of the semiconductor laser according to the first embodiment of the present invention.

As shown in FIG. 2a, FIG. 2b, and FIG. 2c, the x axis represents a slow axis direction, the y axis represents a fast axis direction, and the z axis represents the other direction of a three-dimensional space. The semiconductor chip of the present invention is described using an LD chip as an example.

The semiconductor laser includes a semiconductor gain module 1. The semiconductor gain module 1 includes a semiconductor chip 1-1. The semiconductor chip 1-1 includes a light-emitting unit 1-11, a front end surface, and a rear end surface. In this embodiment, "front" refers to the forward direction of the z axis, and "rear" refers to the backward direction of the z axis. In FIG. 2a, the front end surface is a side close to a fast-axis collimating element FAC, and the rear end surface is the other side slightly farther from the fast-axis collimating element FAC.

The light-emitting unit includes an electrode 1-11B, an optical waveguide region 1-11C, and a gain region 1-11A from top to bottom. The length of the gain region in the slow axis direction is 1 mm-10 cm. A center line of the gain region 1-11A is a laser beam section 1-11Aa.

It should be noted that for one light-emitting unit, the length of the gain region is 1 mm-10 cm; and for M light-emitting units, the M gain regions are connected in series in an optical path, and the sum of the lengths of the gain regions of the light-emitting units in the slow axis direction is 1 mm-10 cm.

The semiconductor laser also includes a laser resonant cavity configured to adjust semiconductor laser emitted by the light-emitting unit 1-11 to resonate in the slow axis direction, so that the size of the gain region 1-11A of the light-emitting unit 1-11 in the slow axis direction matches a fundamental mode spot radius $\omega_0$, and thus a large mode field distribution matching the gain region is formed on the semiconductor chip 1-1.

In a preferred embodiment, the size of the gain region 1-11A of the light-emitting unit 1-11 in the slow axis direction matches the fundamental mode spot radius $\omega_0$ such that: a ratio of a length of laser emitted by a single light-emitting unit 1-11 in the slow axis direction to a projection value of a fundamental mode spot diameter $2\omega_0$ in the slow axis direction of the gain region 1-11A is 1-4.

The semiconductor laser also includes a fast-axis collimating element FAC, which is disposed at a distance $f_{FAC}$ in front of the front end face of the light-emitting unit 1-11, and is configured to collimate the laser emitted by the light-emitting unit 1-11 in the fast axis direction.

Further, the fast-axis collimating element FAC is a short-focal-length cylindrical lens, which is disposed in the laser resonant cavity at the front end of the gain region 1-11A, and focuses in the fast axis direction of the gain region 1-11A with a focal length $f_{FAC}$ of 0.3-1.5mm, and a focal length of $\infty$ in the slow axis direction of the gain region 1-11A. That is, in the fast axis direction, the light-emitting unit 1-11 is disposed at a focal point of the fast-axis collimating element, which facilitates collimating the laser emitted by the light-emitting unit 1-11.

Specifically, the semiconductor gain module 1 includes one semiconductor chip 1-1. The semiconductor chip 1-1 includes one light-emitting unit 1-11 with a ridge width of 1-2 mm. The laser resonant cavity is a stable cavity in the slow axis direction.

More specifically, the laser resonant cavity includes a first cavity mirror 2 and a first output coupling mirror 3.

The first cavity mirror 2 is a concave mirror with a concave surface facing the light-emitting unit 1-11 with a radius of curvature of R. The first cavity mirror 2 reflects laser incident on a surface thereof to the light-emitting unit of the semiconductor chip for being output through the first output coupling mirror 3. The laser incident on the surface thereof includes laser emitted by the light-emitting unit or laser reflected to the surface of the first cavity mirror.

Preferably, the front end surface of the semiconductor chip 1-1 is plated with a film having a high transmittance, and the rear end surface thereof is plated with a film having a high reflectivity. The concave surface of the first cavity mirror 2 is plated with a film having a high reflectivity. The first output coupling mirror 3 is plated with a partially transmissive film having a transmittance higher than 40%. A light transmitting surface of the fast-axis collimating element FAC is plated with a film having a high transmittance for the output laser.

Further specifically, the above-mentioned semiconductor laser further includes a heat sink 13, which is disposed below the semiconductor chip 1-1 for dissipating heat therefrom.

It should be noted that, in general, in the stable-cavity semiconductor laser according to the foregoing embodiment of the present invention, the output power of a semiconductor laser in case that the ridge width of the light-emitting unit is 1 mm can be doubled compared with that in case that the ridge width is 0.5 mm. The output power in case that the ridge width of the light-emitting unit is 2 mm can be increased to 4 times compared with that in case that the ridge width is 0.5 mm.

It should also be noted that a ratio of the length of the laser emitted by the light-emitting unit in the slow axis direction to the ridge width is x (in view that x is related to the current, the chip itself and other factors, it is generally about 1.2-1.8, and it is estimated as 1.4 in the present invention).

In addition, in order to make the side view capable of displaying the laser oscillation in the cavity not cumbersome, each time the FAC mirror is not completely added during the round trip, which is only a schematic diagram.

It can be seen from FIG. 1 that when the external cavity is 500 mm in length and the spot radius $\omega_0$ is 0.36 mm, the fundamental mode spot diameter $2\omega_0$ is 0.72 mm. If the ratio of the length of the laser emitted by the single light-emitting unit in the slow axis direction to the projection value of the fundamental mode spot diameter $2\omega_0$ on the chip is 1-4, then, according to experience, if the length of the laser emitted by the single light-emitting unit in the slow axis direction is 0.72x2≈2.8, the beam quality $M^2$ is about 2, and the corresponding ridge width is 2.8 / x = 2.8 / 1.4 = 2mm.

In the semiconductor laser according to the first embodiment of the present invention, the length of the gain region of the semiconductor laser in the slow axis direction is set to 1 mm-10 cm, and a laser resonant cavity is provided to adjust the semiconductor laser emitted by the light-emitting unit to resonate in the slow axis direction so that the fundamental mode spot radius $\omega_0$ in the slow axis direction matches the length of the gain region of the light-emitting unit in the slow axis direction, which on one hand can improve the high-power output capability of the gain region, and on the other hand, can improve the beam quality and achieve high beam quality output with $M^2 <2$.

Embodiment II

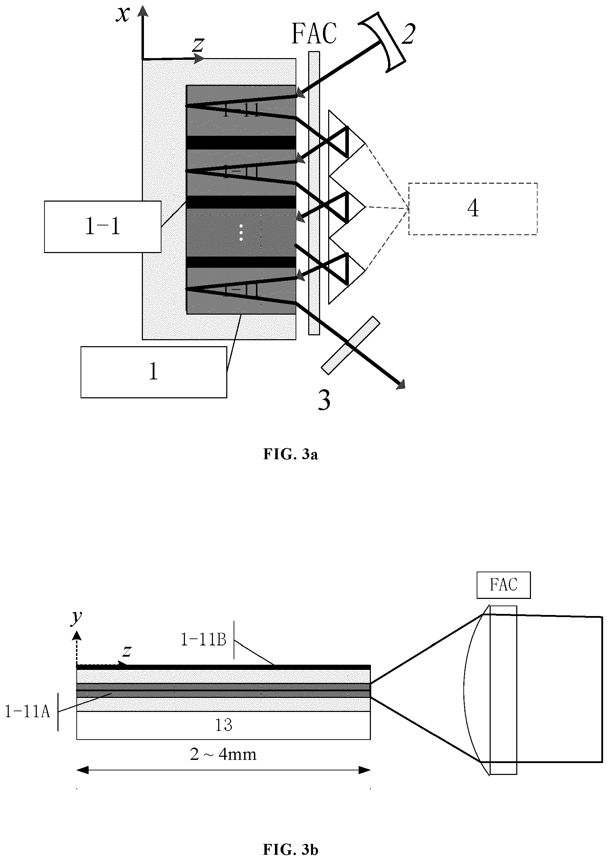

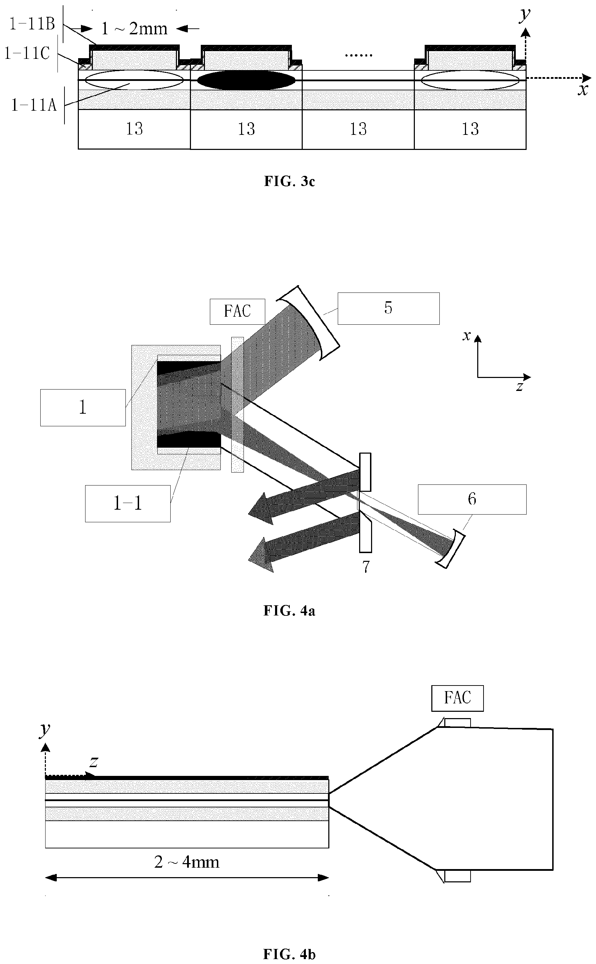

FIG. 3a is a top view of a semiconductor laser according to a second embodiment of the present invention; FIG. 3b is a side view of the semiconductor laser according to the second embodiment of the present invention; and FIG. 3c is a front view of the semiconductor laser according to the second embodiment of the present invention.

As shown in FIG. 3a, FIG. 3b, and FIG. 3c, the x-axis represents a slow axis direction, the $\gamma$-axis represents a fast axis direction, and the z-axis represents the other direction of a three-dimensional space. In this embodiment, "front" refers to the forward direction of the z axis, and "rear" refers to the backward direction of the z axis. In FIG. 2a, the front end surface is a side close to a fast-axis collimating element FAC, and the rear end surface is the other side slightly farther from the fast-axis collimating element FAC.

The semiconductor laser includes a semiconductor gain module 1. The semiconductor gain module 1 includes one semiconductor chip 1-1. The semiconductor chip 1-1 includes M light-emitting units 1-11, a front end surface, and a rear end surface. The distance from the front end surface to the rear end surface is 2 to 4 mm. Each light-emitting unit 1-11 includes an electrode 1-11B, an optical waveguide region 1-11C, and a gain region 1-11A from top to bottom. The total length of the gain regions of the M light-emitting units 1-11 in the slow axis direction is 1 mm-10 cm.

The semiconductor laser also includes a laser resonant cavity configured to adjust semiconductor laser emitted by the light-emitting unit 1-11 to resonate in the slow axis direction, so that the size of the gain region 1-11A of the light-emitting unit 1-11 in the slow axis direction matches a fundamental mode spot radius $\omega_0$, and thus a large mode field distribution matching the gain region is formed on the semiconductor chip 1-1.

In a preferred embodiment, the size of the gain region 1-11A of the light-emitting unit 1-11 in the slow axis direction matches the fundamental mode spot radius $\omega_0$ such that: a ratio of a length of laser emitted by a single light-emitting unit 1-11 in the slow axis direction to a projection value of a fundamental mode spot diameter $2\omega_0$ in the slow axis direction of the gain region 1-11A is 1-4.

The semiconductor laser also includes a fast-axis collimating element FAC, which is disposed in the laser resonant cavity and is configured to collimate the laser emitted by the light-emitting units 1-11 in the fast axis direction.

Further, the fast-axis collimating element FAC is a short-focal-length cylindrical lens, which is arranged at a distance $f_{FAC}$ from the front end surface of the light-emitting unit 1-11 at the front end of the gain region 1-11A with a focal length $f_{FAC}$ of 0.3-1.5 mm in the fast axis direction of the gain region 1-11A and a focal length of $\infty$ in the slow axis direction of the gain region 1-11A.

Specifically, the semiconductor gain module 1 includes one semiconductor chip 1-1. The semiconductor chip 1-1 includes M light-emitting units 1-11 with a ridge width of 1-2 mm. $M \geqq 2$. The M light-emitting units 1-11 are connected in series in the slow axis direction. Preferably, the M light-emitting units are arranged at equal intervals.

More specifically, the laser resonant cavity is a stable cavity in the slow axis direction. The laser resonant cavity includes a first cavity mirror 2, a first output coupling mirror 3, and a roof prism 4.

The first cavity mirror 2 is a concave mirror with a concave surface facing the light-emitting units 1-11 with a radius of curvature of R.

The laser emitted by the light-emitting unit 1-11 is emitted to the first cavity mirror 2, reflected by the first cavity mirror 2 to the rear end surface of the semiconductor chip 1-1, and output through the first output coupling mirror 3.

The roof prism 4 is disposed in front of the fast-axis collimating element FAC, and is configured to reflect the laser emitted by the M light-emitting units 1-11 to the gain region 1-11A until being output by the first output coupling mirror 3.

Preferably, there are M-1 roof prisms. The role of the roof prism 4 is to return the laser to the chip. If other optical elements with similar functions are configured to achieve the same function, the roof prism 4 can also be replaced.

Further specifically, the above-mentioned semiconductor laser further includes a heat sink 13, which is disposed below the semiconductor chip 1-1 for dissipating heat therefrom.

In one example, a side of the first cavity mirror 2 close to the fast-axis collimating element FAC is plated with a film having a high reflectivity, and the first output coupling mirror 3 is plated with a partially transmissive film having a transmittance higher than 40%; the front end surface of the semiconductor chip 1-1 is plated with a film having a high transmittance, and the rear end surface thereof is plated with a film having a high reflectivity, and a light transmitting surface of the fast-axis collimating element (FAC) is plated with a film having a high transmittance for the output laser.

The semiconductor laser according to the second embodiment of the present invention has the following advantages:

(1) For the semiconductor laser according to the second embodiment of the present invention, a total length of a gain region of a semiconductor laser in a slow axis direction is set to 1 mm-10 cm. A laser resonant cavity is provided to adjust semiconductor laser emitted by a light-emitting unit to resonate in the slow axial direction, so that the length of the gain region of the light-emitting unit in the slow axis direction matches the size of a fundamental mode spot in the slow axis direction, which on the one hand can improve the high-power output capability of the gain region, and on the other hand can improve the beam quality and achieve high beam quality output with $M^2 < 2$.

(2) In the semiconductor laser according to the foregoing embodiment, M light-emitting units are disposed on one semiconductor chip. Compared with a semiconductor laser where one light-emitting unit is provided on one semiconductor chip, the output power can be increased by M times in principle.

Embodiment III

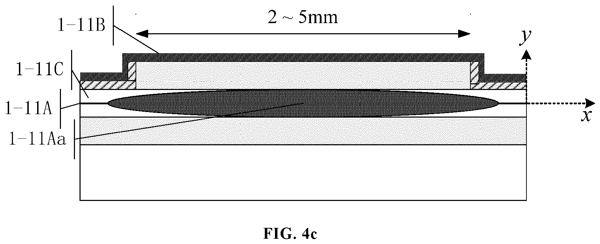

FIG. 4a is a top view of a semiconductor laser according to a third embodiment of the present invention; FIG. 4b is a side view of the semiconductor laser according to the third embodiment of the present invention; and FIG. 4c is a front view of the semiconductor laser according to the third embodiment of the present invention.

As shown in FIG. 4a and FIG. 4b, the x-axis represents a slow axis direction, the y-axis represents a fast axis direction, and the z-axis represents the other direction of a three-dimensional space.

The semiconductor laser includes a semiconductor gain module 1. The semiconductor gain module 1 includes one semiconductor chip 1-1. The semiconductor chip 1-1 includes one light-emitting unit 1-11, a front end surface, and a rear end surface. The light-emitting unit 1-11 includes an electrode 1-11B, an optical waveguide region 1-11C, and a gain region 1-11A from top to bottom. The length of the gain region in the slow axis direction is 1 mm-10 cm. A center line of the gain region 1-11A is a laser beam section 1-11Aa.

The semiconductor laser also includes a laser resonant cavity configured to adjust semiconductor laser emitted by the light-emitting unit 1-11 to resonate in the slow axis direction, so that the size of the gain region 1-11A of the light-emitting unit 1-11 in the slow axis direction matches a fundamental mode spot radius $\omega_0$, and thus a large mode field distribution matching the gain region is formed on the semiconductor chip 1-1.

In a preferred embodiment, the size of the gain region 1-11A of the light-emitting unit 1-11 in the slow axis direction matches the fundamental mode spot radius $\omega_0$ such that: a ratio of a length of laser emitted by a single light-emitting unit 1-11 in the slow axis direction to a projection value of a fundamental mode spot diameter $2\omega_0$ in the slow axis direction of the gain region 1-11A is 1-4.

The semiconductor laser also includes a fast-axis collimating element FAC, which is disposed in the laser resonant cavity and is configured to collimate the laser emitted by the light-emitting units 1-11 in the fast axis direction.

Further, the fast-axis collimating element FAC is disposed at a distance $f_{Fac}$ in front of the front end face of the light-emitting unit 1-11, and the laser emitted by the fast-axis collimating element FAC focuses in the fast axis direction of the gain region 1-11A with a focal length of $f_{Fac}$ in the fast axis direction of the gain region 1-11A and a focal length of $\infty$ in the slow axis direction of the gain region 1-11A.

Further, the fast-axis collimating element FAC is a short-focal-length cylindrical lens with a focal length of 0.3-1.5 mm in the fast axis direction.

Specifically, the semiconductor gain module 1 includes one semiconductor chip 1-1. The semiconductor chip 1-1 includes one light-emitting unit 1-11 with a ridge width of 2-5 mm.

More specifically, the laser resonant cavity is an unstable cavity in the slow axis direction. The laser resonant cavity includes a second cavity mirror 5, a third cavity mirror 6, and a second output coupling mirror 7.

Specifically, the second cavity mirror 5 is configured to reflect laser incident on a surface thereof to the semiconductor chip 1-1; a hole is disposed in the center of the second output coupling mirror 7, and the second output coupling mirror 7 reflects and outputs laser incident on a surface thereof; and the third cavity mirror 6 is configured to reflect the laser passing through the hole to the semiconductor chip 1-1.

More specifically, the second cavity mirror 5 is a concave mirror with a concave surface facing the light-emitting unit 1-11 and is disposed in front of the fast-axis collimating element (FAC). The second output coupling mirror 7 is disposed in front of the fast-axis collimating element FAC, and has a certain angle $\alpha$ with an optical path in the laser resonant cavity. The laser emitted by the light-emitting unit 1-11 passes through the central hole of the second output coupling mirror 5 and focuses in vicinity of the central hole of the second output coupling mirror 7 to form a focal point after being reflected by the third cavity mirror 6, so that the spot when passing through the central hole is small. The third cavity mirror 6 is a concave mirror and is disposed in front of the second output coupling mirror 7.

Optionally, the second output coupling mirror may be in the shape of a ring, or may be similar to the shape of a Chinese copper coin, etc. That is, the outer edge of the second output coupling mirror may be circular, and the central hole thereof may be circular, oval, square, or the like.

It should be noted that, in the semiconductor laser according to the third embodiment of the present invention, since the optical path is reversible, the positions of the second cavity mirror 5 and the second output coupling mirror 7 are interchangeable. Of course, the third cavity mirror 6 needs to be disposed on the optical path of the central hole of the second cavity mirror 7 so that the light transmitted through the central hole of the second cavity mirror 7 is emitted onto the surface of the third cavity mirror 6 and reflected back to the gain region 1-11A of the light-emitting unit 1-11 in the same optical path.

In a preferred embodiment, the second output coupling mirror 7 is plated with a highly reflective film for a laser angle of 90-$\alpha$; the front end surface of the semiconductor chip 1-1 is plated with a film having a high transmittance for the output laser wavelength, and the rear end surface thereof is plated with a film having a high reflectivity for the output laser wavelength; and a light transmitting surface of the fast-axis collimating element FAC is plated with a film having a high transmittance for the output laser.

In this embodiment, by taking a case in that the laser in the semiconductor laser is oscillated twice as an example, the oscillation path of the laser in the semiconductor laser will be described in detail.

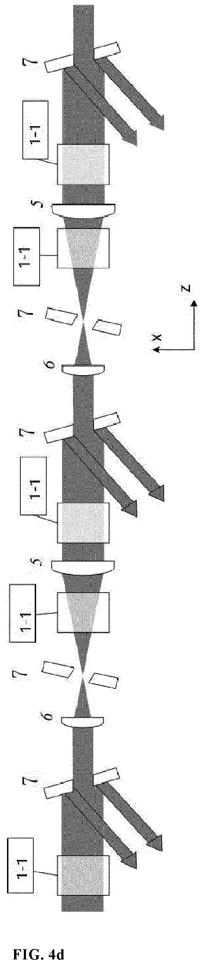

FIG. 4d is a schematic diagram (slow axis direction) of a laser oscillation path in the semiconductor laser according to the third embodiment of the present invention.

As shown in FIG. 4d, the light-emitting units 1-11 of the semiconductor chip in the semiconductor laser emit laser. In the slow axis direction, a part of the laser is reflected by the second coupling output mirror 7 to output hollow laser, and another part of the laser passes through the central hole of the second coupling output mirror 7 to the third cavity mirror 6, focuses and diverges after being reflected from the third cavity mirror to the vicinity of the central hole of the second coupling output mirror 7, and then returns to the gain region 1-11A of the light-emitting unit 1-11. After being amplified by the gain region 1-11A, this part of the laser is reflected to the surface of the second cavity mirror 5 and collimated by the second cavity mirror 5 and reflected back to the gain region 1-11A of the light-emitting unit 1-11. After being subjected to gain amplification again by the gain region, a part of the laser is emitted on the surface of the second output coupling mirror 7 to form a hollow laser output, and the other part of the laser passes through the central hole of the second coupling output mirror 7 to the third cavity mirror 6, and the laser oscillates continuously in the semiconductor laser to continuously output hollow laser. In the fast axis direction, the laser forms a resonance between the cavity mirror and the chip, which is well known to those skilled in the art, and will not be repeated here.

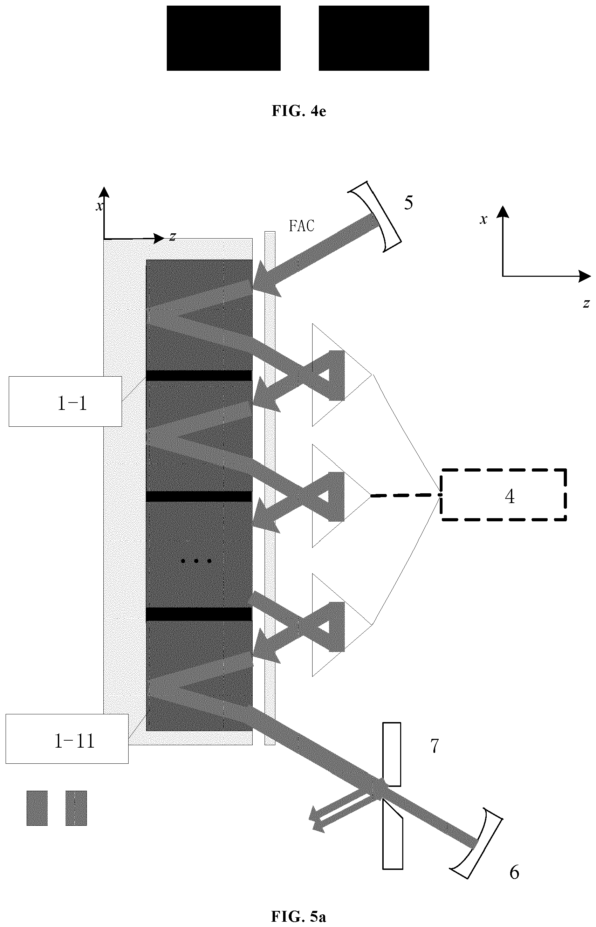

FIG. 4e is a schematic diagram of the shape of laser output from the semiconductor laser according to the third embodiment of the present invention.

The laser output from the unstable-cavity semiconductor laser is hollow laser.

For the semiconductor laser according to the third embodiment of the present invention, a total length of a gain region of a semiconductor laser in a slow axis direction is set to 1 mm-10 cm. A laser resonant cavity is provided to adjust semiconductor laser emitted by a light-emitting unit to resonate in the slow axial direction, so that the length of the gain region of the light-emitting unit in the slow axis direction matches the size of a fundamental mode spot in the slow axis direction, which on the one hand can improve the high-power output capability of the gain region, and on the other hand can improve the beam quality and achieve high beam quality output with $M^2 < 2$.

Embodiment IV

FIG. 5a is a top view of a semiconductor laser according to a fourth embodiment of the present invention.

As shown in FIG. 5a, the x-axis represents a slow axis direction, the y-axis represents a fast axis direction, and the z-axis represents the other direction of a three-dimensional space.

In the fourth embodiment, the laser emitted by the light-emitting unit 1-11 is reflected back to the light-emitting unit 1-11 through the second cavity mirror 5 and is reflected back to the light-emitting unit through the roof prism until the laser is output through the surface of the second output coupling mirror 7. The output laser is hollow laser.

The difference between the semiconductor laser according to the fourth embodiment of the present invention and the semiconductor laser according to the third embodiment lies in that in the fourth embodiment, M light-emitting units are disposed on the chip, while in the third embodiment, one light-emitting unit is disposed on the chip. Therefore, the side view of the semiconductor laser according to the fourth embodiment is the same as the semiconductor laser according to the third embodiment, and the same parts as the third embodiment are not described in this embodiment.

The semiconductor laser according to the fourth embodiment of the present invention includes one semiconductor chip 1-1. The semiconductor chip 1-1 includes M light-emitting units 1-11. A ridge width of each light-emitting unit is 2-5 mm.

Preferably, the M light-emitting units 1-11 are disposed in series at equal intervals in the slow axis direction.

Specifically, the laser resonant cavity is an unstable cavity in the slow axis direction. The laser resonant cavity includes a second cavity mirror 5, a third cavity mirror 6, and a second output coupling mirror 7.

The second cavity mirror 5 is configured to reflect the laser emitted from the light-emitting unit 1-11 to the rear end surface of the semiconductor chip 1-1 for being output through the second output coupling mirror 7. A hole is disposed in the center of the second output coupling mirror 7 which is configured to reflect and output the laser incident on a surface thereof to obtain the output laser of the semiconductor laser. The third cavity mirror 6 reflects the laser passing through the hole to the semiconductor chip 1-1.

Specifically, the second cavity mirror 5 is a concave mirror with a concave surface facing the light-emitting unit 1-11 and is disposed in front of the fast-axis collimating element FAC.

The second output coupling mirror 7 is disposed in front of the fast-axis collimating element FAC and has a certain angle $\alpha$ with an optical path in the laser resonant cavity; and the laser emitted by the light-emitting unit 1-11 passes through the central hole of the second output coupling mirror 7 and focuses in vicinity of the central hole of the second output coupling mirror 7 to form a focal point after being reflected by the third cavity mirror 6, so that the spot when passing through the central hole is small.

The third cavity mirror 6 is a concave mirror and is disposed in front of the second output coupling mirror 7.

The above-mentioned laser resonant cavity further includes a roof prism 4, which is disposed in front of the fast-axis collimating element FAC, and is configured to reflect the laser emitted by the M light-emitting units 1-11 to the gain region 1-11A for being output through the second output coupling mirror 7. Optionally, there are M-1 roof prisms 4.

It should be noted that M-1 roof prisms can also be made into one roof prism for easy installation.

In a preferred embodiment, the second output-coupling mirror 7 is plated with a highly reflective film for a laser angle of 90-$\alpha$.

The concave surfaces of the second cavity mirror 5 and the third cavity mirror 6 are plated with a film having a high reflectivity; the second output coupling mirror 7 is plated with a highly reflective film for a laser angle of 90-$\alpha$; the front end surface of the semiconductor chip 1-1 is plated with a film having a high transmittance for the output laser wavelength, and the rear end surface thereof is plated with a film having a high reflectivity for the output laser wavelength; and a light transmitting surface of the fast-axis collimating element FAC is plated with a film having a high transmittance for the output laser.

Further specifically, the above-mentioned semiconductor laser further includes a heat sink 13, which is disposed below the semiconductor chip 1-1 for dissipating heat therefrom.

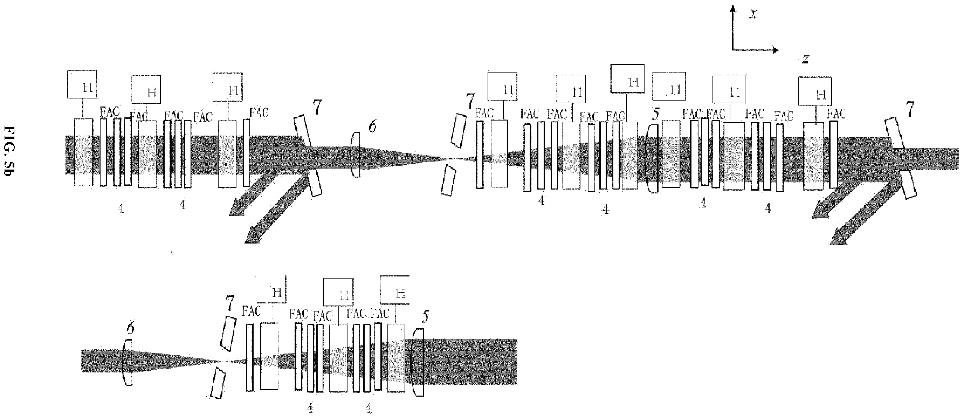

FIG. 5b is a schematic diagram of an oscillation path of laser in the semiconductor laser according to the fourth embodiment of the present invention.

As shown in FIG. 5a and FIG. 5b, the semiconductor chip 1-1 is provided with first, second, and M-th light-emitting units, and first, second, and M-1 ridge prisms are provided between adjacent light-emitting units 1-1. In the slow axis direction, the M-th light-emitting unit of the semiconductor chip in the semiconductor laser emits laser, part of the laser is reflected by the second coupling output mirror 7 to output hollow laser, and another part of the laser passes through the central hole of the second coupling output mirror 7 to the third cavity mirror 6, focuses and diverges after being reflected from the third cavity mirror 6 to the vicinity of the central hole of the second coupling out mirror 7, returns to the M-th light-emitting unit closest to the second coupling out mirror 7. After gain amplification by the M-th light-emitting unit, this part of the laser is emitted to the (M-1)-th roof prism and folded back to the (M-1)-th light-emitting unit. After gain amplification by the (M-1)-th light-emitting unit, the laser is emitted to the (M-2)-th roof prism and folded back to the (M-2)-th light-emitting unit. After gain amplification by a plurality of light-emitting units, the laser is emitted from the first light-emitting unit to the surface of the second cavity mirror 5 and reflected in collimated manner by the second cavity mirror 5 back to the first light-emitting unit closest to the second cavity mirror 5. Then, after gain amplification by the plurality of light-emitting units and folding-back by the roof prism, the laser is emitted from the M-th light-emitting unit, part of the laser is reflected by the second coupling output mirror 7 to output hollow laser, and another part of the laser continues to subject to gain amplification in the cavity again, thus forming laser oscillation.

The semiconductor laser according to the fourth embodiment of the present invention has the following advantages:

(1) For the semiconductor laser according to the fourth embodiment of the present invention, a total length of a gain region of a semiconductor laser in a slow axis direction is set to 1 mm-10 cm. A laser resonant cavity is provided to adjust semiconductor laser emitted by a light-emitting unit to resonate in the slow axial direction, so that the length of the gain region of the light-emitting unit in the slow axis direction matches the size of a fundamental mode spot in the slow axis direction, which on the one hand can improve the high-power output capability of the gain region, and on the other hand can improve the beam quality and achieve high beam quality output with $M^2 < 2$.

(2) In the semiconductor laser according to the foregoing embodiment, M light-emitting units are disposed on one semiconductor chip. Compared with a semiconductor laser where one light-emitting unit is provided on one semiconductor chip, the output power can be increased by M times.

Embodiment V

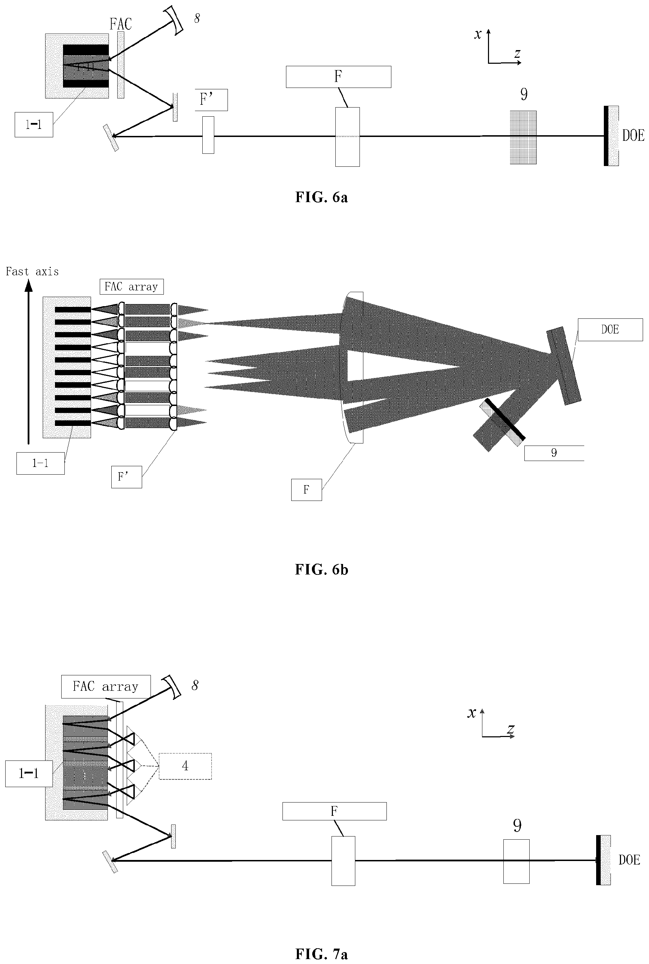

FIG. 6a is a top view of a semiconductor laser according to a fifth embodiment of the present invention; FIG. 6b is a side view of the semiconductor laser according to the fifth embodiment of the present invention; and FIG. 6b also shows a resonant optical path in the fast axis direction.

As shown in FIG. 6a and FIG. 6b, the x-axis represents a slow axis direction, the $\gamma$-axis represents a fast axis direction, and the z-axis represents the other direction of a three-dimensional space.

The semiconductor laser according to the fifth embodiment of the present invention is different from the first embodiment in that N chips are arranged vertically in the fast axis direction to perform external cavity spectral beam combining. The side view and the front view of a single light-emitting unit thereof are the same as the side view and the front view shown in the first embodiment, and the same structure will not be repeated here.

The semiconductor laser includes a plurality of semiconductor chips 1-1. Each semiconductor chip 1-1 is provided with one light-emitting unit. The length of the gain region 1-11A of the light-emitting unit 1-11 in the slow axis direction is 1 mm-10 cm.

Preferably, the plurality of semiconductor chips 1-1 are arranged vertically in the fast axis direction and parallel to each other in the slow axis direction. More preferably, the plurality of semiconductor chips 1-1 are arranged at equal intervals.

It should be noted that the plurality of semiconductor chips are arranged vertically in the fast axis direction and parallel to each other in the slow axis direction such that the optical path in the resonant cavity can achieve feedback and beam combining in the fast axis direction. If they are not parallel in the slow axis direction, the cavity is difficult to design and adjust. The plurality of semiconductor chips 1-1 being arranged at equal intervals shows a better laser beam combining effect in the fast axis direction, the heat dissipation is uniform, and the light path is easy to adjust.

The above semiconductor laser further includes a laser resonant cavity. On the one hand, the laser resonant cavity is configured to adjust the semiconductor laser emitted by the light-emitting unit 1-11 to resonate, so that the size of the gain region 1-11A of the light-emitting unit 1-11 in the slow axis direction matches a fundamental mode spot radius $\omega_0$, and thus a large mode field distribution matching the gain region is formed on the semiconductor chip 1-1. On the other hand, the laser resonant cavity is further configured to adjust the laser emitted by the plurality of semiconductor chips (1-1) to perform spectral synthesis in the fast axis direction.

In a preferred embodiment, the size of the gain region 1-11A of the light-emitting unit 1-11 in the slow axis direction matches the fundamental mode spot radius $\omega_0$ such that: a ratio of a length of laser emitted by a single light-emitting unit 1-11 in the slow axis direction to a projection value of a fundamental mode spot diameter $2\omega_0$ in the slow axis direction of the gain region 1-11A is 1-4.

A fast-axis collimating element FAC is disposed in the laser resonant cavity and is configured to collimate the laser emitted by the light-emitting units 1-11 in the fast axis direction.

Specifically, the fast-axis collimating element FAC is disposed at a certain distance $f_{FAC}$ in front of the front end surface of the light-emitting unit 1-11; the laser emitted by the light-emitting unit 1-11 focuses in the fast axis direction of the gain region 1-11A with a focal length of $f_{FAC}$ and a focal length of $\infty$ in the slow axis direction of the gain region 1-11A. Preferably, the fast-axis collimating element FAC is a short-focal-length cylindrical lens with a focal length of 0.3-1.5 mm in the fast axis direction.

The laser resonant cavity is a stable cavity in the slow axis direction. The laser resonant cavity includes a fourth cavity mirror 8, a third output coupling mirror 9, a cylindrical conversion lens F, and a diffractive optical element DOE.

The fourth cavity mirror 8 is configured to reflect laser incident on a surface thereof to the gain region of the semiconductor chip 1-1 for being output through the third output coupling mirror 9. Optionally, the fourth cavity mirror 8 is a concave mirror with a concave surface facing the light-emitting unit 1-11.

The cylindrical conversion lens F is provided with a certain focal length f in the fast axis direction and a focal length of $\infty$ in the slow axis direction; the gain region 1-11A and the diffractive optical element DOE are disposed on two focal points of the cylindrical conversion lens F, respectively. In the semiconductor laser according to the fifth embodiment of the present invention, the direction of the optical path in the laser resonant cavity is: the laser emitted by the light-emitting unit 1-11 is emitted to the surface of the fourth cavity mirror 8 through the fast-axis collimating element FAC, reflected to the gain region of the light-emitting unit 1-11, transmitted through the fast-axis collimating element FAC after gain amplification and focused on the diffractive optical element DOE through two reflecting mirrors and the cylindrical conversion lens F respectively, and then reflected to the surface of the third output coupling mirror 9 for being output through the third output coupling mirror 9.

In a preferred embodiment, a cylindrical conversion lens F' can be further added between the FAC and the cylindrical conversion lens F. The cylindrical conversion lenses F and F' form a cylindrical conversion lens group. In the fast axis direction, the laser emitted by the chip is collimated and output by the FAC, and is focused at the left focal point of the cylindrical conversion lens F after passing through the cylindrical conversion lens F'. The laser is collimated by the cylindrical conversion lens F, and after being subjected to beam combining by the diffractive optical elements DOE, the laser is reflected to the surface of the third output coupling mirror 9 for being output through the third output coupling mirror 9.

In a preferred embodiment, the concave surface of the fourth cavity mirror 8 is plated with a film having a high reflectivity for output laser wavelength; the third output coupling mirror 9 is plated with a partially transmissive film for the output laser wavelength with a transmittance higher than 40%; the front end surface of semiconductor chip 1-1 is plated with a film having a high transmittance for the output laser wavelength, and the rear end surface is plated with a film having a high reflectivity for the output laser wavelength, and a light transmitting surface of the fast-axis collimating element FAC is plated a film having a high transmittance for the output laser.

In a preferred embodiment, the semiconductor laser further includes a heat sink 13, which is disposed below the semiconductor chip 1-1 and configured to dissipate heat from the semiconductor chip 1-1.

The semiconductor laser according to the fifth embodiment of the present invention has the following advantages:

(1) For the semiconductor laser according to the fifth embodiment of the present invention, a total length of a gain region of a semiconductor laser in a slow axis direction is set to 1 mm-10 cm. A laser resonant cavity is provided to adjust semiconductor laser emitted by a light-emitting unit to resonate in the slow axial direction, so that the length of the gain region of the light-emitting unit in the slow axis direction matches the size of a fundamental mode spot in the slow axis direction, which on the one hand can improve the high-power output capability of the gain region, and on the other hand can improve the beam quality and achieve high beam quality output with $M^2 < 2$.

(2) The semiconductor laser according to the fifth embodiment of the present invention is provided with N chips in the fast axis direction, and the laser emitted by the N chips is spectrally combined in the fast axis direction through the laser resonant cavity, which can improve the output power of the semiconductor laser. Compared with a semiconductor laser with one chip, the output power of a semiconductor laser with N chips can be increased by N times.

Embodiment VI

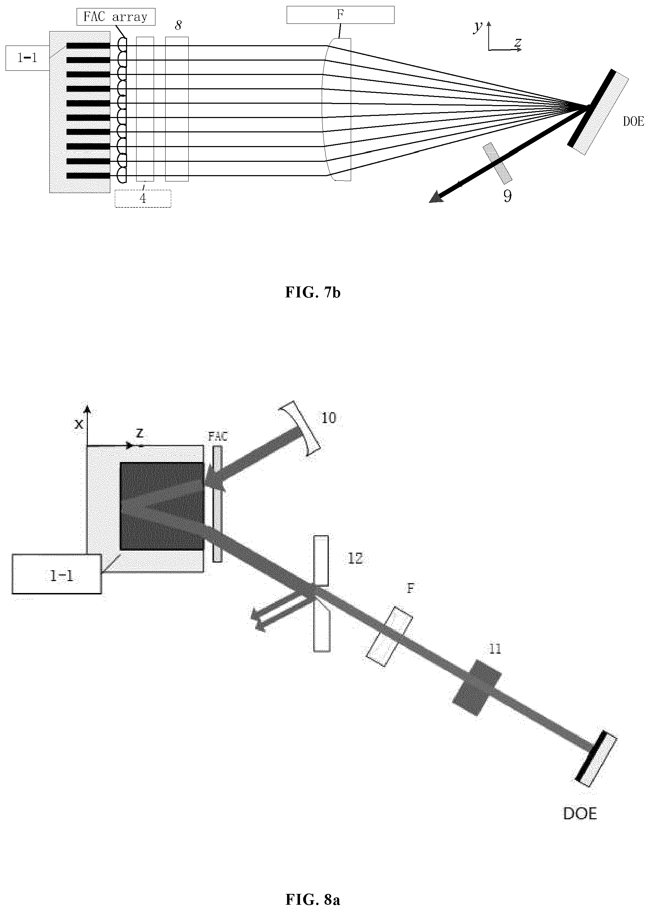

FIG. 7a is a top view of a semiconductor laser according to a sixth embodiment of the present invention; and FIG. 7b is a side view of the semiconductor laser according to the sixth embodiment of the present invention.

The semiconductor laser according to the sixth embodiment of the present invention is different from the second embodiment in that N chips are arranged vertically in the fast axis direction to perform external cavity spectral beam combining, and the same structure will not be described again here. The structure and principle of the fast-axis beam combining portion are also similar to those in the fifth embodiment of the present invention.

As shown in FIG. 7a and FIG. 7b, the x-axis represents a slow axis direction, the γ-axis represents a fast axis direction, and the z-axis represents the other direction of a three-dimensional space. In this embodiment, "front" refers to the forward direction of the z axis, and "rear" refers to the backward direction of the z axis. In FIG. 7a, the front end surface is a side close to the fast-axis collimating element FAC, and the rear end surface is the other side slightly farther from the fast-axis collimating element FAC.

The semiconductor laser includes a semiconductor gain module 1. The semiconductor gain module 1 includes a semiconductor chip 1-1. The semiconductor chip 1-1 includes a light-emitting unit 1-11, a front end surface, and a rear end surface.

The light-emitting unit includes an electrode 1-11B, an optical waveguide region 1-11C, and a gain region 1-11A from top to bottom. The length of the gain region in the slow axis direction is 1 mm-10 cm. A center line of the gain region 1-11A is a laser beam section 1-11Aa.

It should be noted that for one light-emitting unit, the length of the gain region is 1 mm-10 cm, and for M light-emitting units, the M gain regions are connected in series in the optical path. The sum of the lengths of the gain regions of the light-emitting units along the slow axis direction is 1 mm-10 cm.

The semiconductor laser also includes a laser resonant cavity. On the one hand, the laser resonant cavity is configured to adjust the semiconductor laser emitted by the light-emitting unit 1-11 to resonate in the slow axis direction, so that the size of the gain region 1-11A of the light-emitting unit 1-11 is in the slow axis direction matches a fundamental mode spot radius $\omega_0$, and thus a large mode field distribution matching the gain region is formed on the semiconductor chip 1-1. On the other hand, the laser resonant cavity is further configured to adjust the laser emitted by the plurality of semiconductor chips 1-1 to perform spectral synthesis in the fast axis direction.

In a preferred embodiment, the size of the gain region 1-11A of the light-emitting unit 1-11 in the slow axis direction matches the fundamental mode spot radius $\omega_0$ such that: a ratio of a length of laser emitted by a single light-emitting unit 1-11 in the slow axis direction to a projection value of a fundamental mode spot diameter $2\omega_0$ in the slow axis direction of the gain region 1-11A is 1-4.

The semiconductor laser also includes a fast-axis collimating element FAC, which is disposed at a distance $f_{FAC}$ in front of the front end face of the light-emitting unit 1-11, and is configured to collimate the laser emitted by the light-emitting unit 1-11 in the fast axis direction.

Further, the fast-axis collimating element FAC is a short-focal-length cylindrical lens, which is disposed in the laser resonant cavity at the front end of the gain region 1-11A, and focuses in the fast axis direction of the gain region 1-11A with a focal length of 0.3-1.5mm and a focal length of $\infty$ in the slow axis direction of the gain region 1-11A.

Specifically, the semiconductor gain module 1 includes N semiconductor chips (N $\geqq$ 2). Each semiconductor chip includes M light-emitting units 1-11 with a ridge width of 1-2 mm. M $\geqq$ 2. The M light-emitting units 1-11 are connected in series in the slow axis direction.

Preferably, the N semiconductor chips 1-1 are arranged vertically in the fast axis direction and parallel to each other in the slow axis direction. More preferably, the N semiconductor chips are arranged at equal intervals.

It should be noted that N chips are arranged vertically in the fast axis direction and parallel to each other in the slow axis direction, only then can the feedback of the external cavity optical path be spectrally beam combined in the fast axis direction. If the N chips are not parallel in the slow axis direction, it is difficult to adjust the external cavity to perform spectral beam combining in the fast axis direction. Moreover, the N chips are arranged at equal intervals. On the one hand, the heat dissipation in the laser resonant cavity is uniform, and on the other hand, the optical path in the laser resonant cavity is easy to adjust.

Preferably, the M light-emitting units are arranged at equal intervals. The M light-emitting units being arranged at equal intervals in the slow axis direction makes it easy for the laser to resonate in the resonant cavity.

The laser resonant cavity is a stable cavity in the slow axis direction. The laser resonant cavity includes a fourth cavity mirror 8, a third output coupling mirror 9, a roof prism 4, a cylindrical conversion lens F, and a diffractive optical element DOE.

The fourth cavity mirror 8 is a concave mirror with a concave surface facing the light-emitting unit 1-11, and is configured to reflect the laser emitted by the light-emitting unit 1-11 to the rear end surface of the semiconductor chip 1-1 for being output through the third output coupling mirror 9.

The roof prism 4 is disposed in front of the fast-axis collimating element FAC, and is configured to reflect the laser emitted by the M light-emitting units 1-11 to the gain region 1-11A for being output through the third output coupling mirror 9. Optionally, there are M-1 roof prisms 4. The M-1 roof prisms can also be made into one roof prism for easy installation.

The cylindrical conversion lens F is provided with a certain focal length f in the fast axis direction and a focal length of $\infty$ in the slow axis direction; and the gain region 1-11A and the diffractive optical element DOE are disposed on two focal points of the cylindrical conversion lens F, respectively.

In one example, the concave surface of the fourth cavity mirror 8 is plated with a film having a high reflectivity for output laser wavelength, and the third output coupling mirror 9 is plated with a partially transmissive film for the output laser wavelength with a transmittance higher than 40%; the front end surface of the semiconductor chip 1-1 is plated with a film having a high transmittance for the output laser wavelength, and the rear surface thereof is plated with a film having a high reflectivity for the output laser wavelength, and a light transmitting surface of the fast-axis collimating element FAC is plated with a film having a high transmittance for the output laser.

In the semiconductor laser according to the sixth embodiment of the present invention, the direction of the optical path in the laser resonant cavity is: the laser emitted by the light-emitting unit 1-11 is emitted to the surface of the fourth cavity mirror 8 through the fast-axis collimating element FAC, and reflected to the gain region of the light-emitting unit 1-11, part of the laser is reflected back to the gain region through the roof prism 4, and after gain amplification, the laser passes through the fast-axis collimating element FAC and passes through two mirrors and the cylindrical conversion lens F to focus to the diffraction optical element DOE and then reflected to the surface of the third output coupling mirror 9 for being output through the third output coupling mirror 9.

The semiconductor laser according to the sixth embodiment of the present invention has the following advantages:

(1) For the semiconductor laser according to the sixth embodiment of the present invention, a total length of a gain region of a semiconductor laser in a slow axis direction is set to 1 mm-10 cm. A laser resonant cavity is provided to adjust semiconductor laser emitted by a light-emitting unit to resonate in the slow axial direction, so that the length of the gain region of the light-emitting unit in the slow axis direction matches the size of a fundamental mode spot in the slow axis direction, which on the one hand can improve the high-power output capability of the gain region, and on the other hand can improve the beam quality and achieve high beam quality output with $M^2 < 2$.

(2) In the semiconductor laser according to the sixth embodiment of the present invention, M light-emitting units are disposed on a semiconductor chip. Compared with a semiconductor chip for which one light-emitting unit is provided on one semiconductor chip, the output power can be increased by M times.

(3) The semiconductor laser according to the sixth embodiment of the present invention is provided with N chips in the fast axis direction, and the laser emitted by the N chips is spectrally combined in the fast axis direction through the laser resonant cavity, which can improve the output power of the gain module. Compared with a semiconductor laser with one chip, the output power of the gain module can be increased by N times.

Embodiment VII

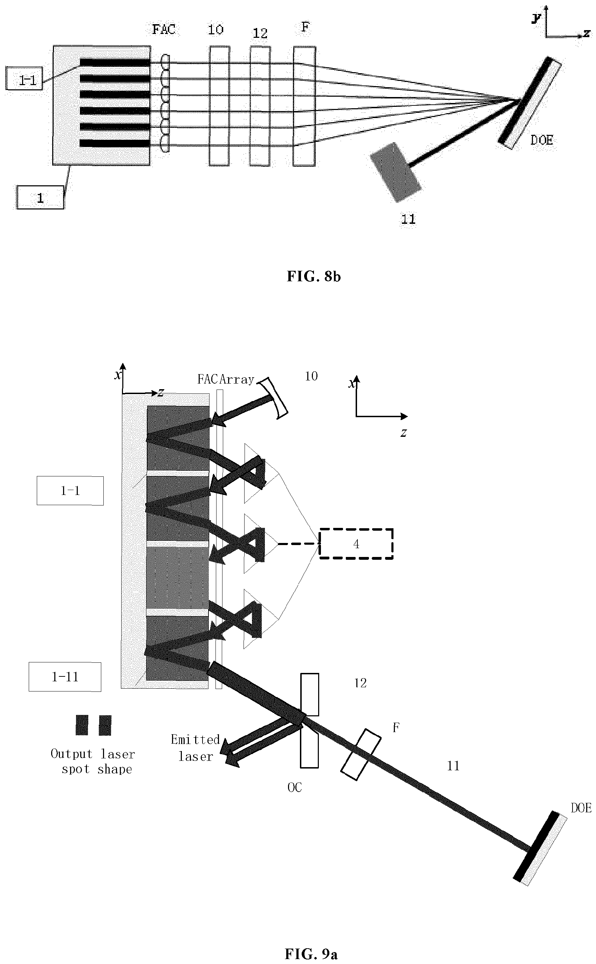

FIG. 8a is a top view of a semiconductor laser according to a seventh embodiment of the present invention; and FIG. 8b is a side view of the semiconductor laser according to the seventh embodiment of the present invention.

The semiconductor laser according to the seventh embodiment of the present invention is similar to the third embodiment, but the difference is that the N chips are arranged vertically in the fast axis direction to perform external cavity spectral beam combining. The same structure will not be repeated here. The fast-axis beam combining portion is similar to that in the fifth embodiment of the present invention.

As shown in FIG. 8a and FIG. 8b, the x-axis represents a slow axis direction, the $\gamma$-axis represents a fast axis direction, and the z-axis represents the other direction of a three-dimensional space. In this embodiment, "front" refers to the forward direction of the z axis, and "rear" refers to the backward direction of the z axis. In FIG. 8a, the front end surface is a side close to the fast-axis collimating element FAC, and the rear end surface is the other side slightly farther from the fast-axis collimating element FAC.

The semiconductor laser includes a semiconductor gain module 1. The semiconductor gain module 1 includes a semiconductor chip 1-1. The semiconductor chip 1-1 includes a light-emitting unit 1-11, a front end surface, and a rear end surface.

The light-emitting unit includes an electrode 1-11B, an optical waveguide region 1-11C, and a gain region 1-11A from top to bottom. The length of the gain region in the slow axis direction is 1 mm-10 cm. A center line of the gain region 1-11A is a laser beam section 1-11Aa.

The semiconductor laser also includes a laser resonant cavity. On the one hand, the laser resonant cavity is configured to adjust the semiconductor laser emitted by the light-emitting unit 1-11 to resonate in the slow axis direction, so that the size of the gain region 1-11A of the light-emitting unit 1-11 in the slow axis direction matches the fundamental mode spot radius $\omega_0$, and thus a large mode field distribution matching the gain region is formed on the semiconductor chip 1-1. On the other hand, the laser resonant cavity is further configured to adjust the laser emitted by the plurality of semiconductor chips 1-1 to perform spectral synthesis in the fast axis direction.

In a preferred embodiment, the size of the gain region 1-11A of the light-emitting unit 1-11 in the slow axis direction matches the fundamental mode spot radius $\omega_0$ such that: a ratio of a length of laser emitted by a single light-emitting unit 1-11 in the slow axis direction to a projection value of a fundamental mode spot diameter $2\omega_0$ in the slow axis direction of the gain region 1-11A is 1-4.

The semiconductor laser also includes a fast-axis collimating element FAC, which is disposed at a distance $f_{FAC}$ in front of the front end face of the light-emitting unit 1-11, and is configured to collimate the laser emitted by the light-emitting unit 1-11 in the fast axis direction.

Further, the fast-axis collimating element FAC is a short-focal-length cylindrical lens, which is disposed in the laser resonant cavity at the front end of the gain region 1-11A, and focuses in the fast axis direction of the gain region 1-11A with a focal length $f_{FAC}$ of 0.3-1.5mm and a focal length of $\infty$ in the slow axis direction of the gain region 1-11A.

Specifically, the above-mentioned semiconductor chip is provided with N semiconductor chips 1-1. The N semiconductor chips 1-1 are arranged vertically in the fast axis direction and parallel to each other in the slow axis direction. The N semiconductor chips are preferably arranged at equal intervals.

It should be noted that a plurality of semiconductor chips are arranged vertically in the fast axis direction and parallel to each other in the slow axis direction, so that the optical path in the resonant cavity can realize the feedback and beam combining in the fast axis direction. If they are not parallel in the slow axis direction, the resonant cavity is difficult to design and adjust. The plurality of semiconductor chips 1-1 being arranged at equal intervals in the fast axis direction shows a better laser beam combining effect, the heat dissipation is uniform, and the light path is easy to adjust.

A ridge width of the light-emitting units 1-11 in each semiconductor chip 1-1 is 2-5 mm; and the laser resonant cavity is an unstable cavity in the slow axis direction.

More specifically, the laser resonant cavity includes a fifth cavity mirror 10, a sixth cavity mirror 11, a fourth output coupling mirror 12, a cylindrical conversion lens F, and a diffractive optical element DOE.

The fifth cavity mirror is configured to reflect laser incident on a surface thereof to the semiconductor chip 1-1; a hole is disposed in the center of the fourth output coupling mirror 12, and the fourth output coupling mirror 12 reflects and outputs the laser incident on a surface thereof; and the sixth cavity mirror 11 is configured to reflect the laser passing through the hole to the semiconductor chip 1-1.

Further, the fifth cavity mirror 10 is a concave mirror with a concave surface facing the light-emitting unit 1-11

and is disposed in front of the fast-axis collimating element FAC; the fourth output coupling mirror 12 is disposed in front of the fast-axis collimating element FAC and has a certain angle $\alpha$ with an optical path in the laser resonate cavity; and the sixth cavity mirror 11 is a concave mirror, and is disposed in front of the fourth output coupling mirror 12.

The cylindrical conversion lens F is provided with a certain focal length f in the fast axis direction and a focal length of $\infty$ in the slow axis direction.

The gain region 1-11A and the diffractive optical element DOE are respectively disposed on two focal points of the cylindrical conversion lens F.

In a preferred embodiment, the semiconductor laser further includes a heat sink 13. The heat sink 13 is disposed below the semiconductor chip 1-1 to dissipate heat from the semiconductor chip 1-1.

In a preferred embodiment, the concave surfaces of the fifth cavity mirror 10 and the sixth cavity mirror 11 are plated with a film having a high reflectivity; the fourth output coupling mirror 12 is plated with a highly reflective film for a laser angle of 90-$\alpha$; the front end face of the semiconductor chip 1- 1 is plated with a film having a high transmittance for the output laser wavelength, and the rear end face thereof is plated with a film having a high reflectivity for the output laser wavelength.

In the semiconductor laser according to the seventh embodiment of the present invention, in the slow axis direction, the oscillation of the laser in the resonant cavity is: the light-emitting unit 1-11 emits laser, and a part of the laser is reflected by the fourth coupling output mirror 12 and is output as hollow laser. The other part of the laser passes through the central hole of the fourth output coupling mirror 12 to the sixth cavity mirror 11, after being converged and reflected by the sixth cavity mirror 11 to the vicinity of the hole of the fourth coupling output mirror 12 to focus and diverge to the gain region 1-11A of the light-emitting unit 1-11. After the gain amplification of the gain region 1-11A, this part of the laser is reflected on the surface of the fifth cavity mirror 10, and is collimated and reflected by the fifth cavity mirror 10 back to the gain region 1-11A of the light-emitting unit 1-11. After gain amplification of the gain region, a part of laser is reflected to the surface of the fourth output coupling mirror 12 to form a hollow laser output, and the laser continuously oscillates in the semiconductor laser to continuously output the hollow laser.

The semiconductor laser according to the seventh embodiment of the present invention has the following advantages:

(1) The semiconductor laser according to the seventh embodiment of the present invention, the length of the gain region of the semiconductor laser in the slow axis direction is set to 1 mm-10 cm, and a laser resonant cavity is provided to adjust the semiconductor laser emitted by the light-emitting unit to resonance in the slow axis direction, so that the size of the fundamental mode spot in the slow axis direction matches the length of the gain region of the light-emitting unit in the slow axis direction. On the one hand, it can improve the high-power output capability of the gain region, and on the other hand, it can improve the beam quality and achieve high beam quality output with $M^2 < 2$.
(2) The semiconductor laser according to the seventh embodiment of the present invention is provided with N chips in the fast axis direction, and the laser emitted by the N chips is spectrally combined in the fast axis direction through the laser resonant cavity, which can improve the output power of the semiconductor laser. Compared with a semiconductor laser with one chip, the output power can be increased by N times.

Embodiment VIII

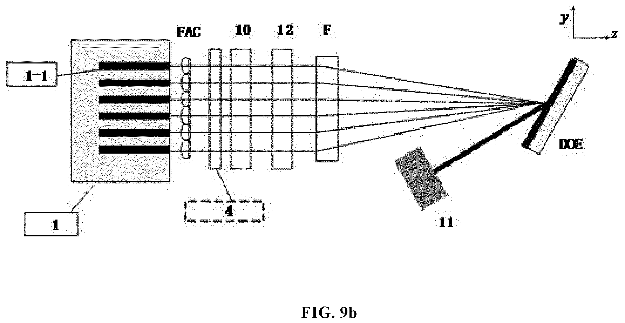

FIG. 9a is a top view of a semiconductor laser according to an eighth embodiment of the present invention; and FIG. 9b is a side view of the semiconductor laser according to the eighth embodiment of the present invention.

The semiconductor laser according to the eighth embodiment of the present invention is similar to that in the fourth embodiment, but the difference is that the N-chips are arranged vertically in the fast axis direction to perform external cavity spectral beam combining. The same structure will not be repeated here. The fast-axis beam combining portion is similar to that in the fifth embodiment of the present invention.

As shown in FIG. 9a and FIG. 9b, the x-axis represents a slow axis direction, the $\gamma$-axis represents a fast axis direction, and the z-axis represents the other direction of a three-dimensional space. In this embodiment, "front" refers to the forward direction of the z axis, and "rear" refers to the backward direction of the z axis. In FIG. 9a, the front end surface is a side close to the fast-axis collimating element FAC, and the rear end surface is the other side slightly farther from the fast-axis collimating element FAC.

The semiconductor laser includes a semiconductor gain module 1. The semiconductor gain module 1 includes a semiconductor chip 1-1. The semiconductor chip 1-1 includes a light-emitting unit 1-11, a front end surface, and a rear end surface.

The semiconductor laser also includes a laser resonant cavity. On the one hand, the laser resonant cavity is configured to adjust the semiconductor laser emitted by the light-emitting unit 1-11 to resonate in the slow axis direction, so that the size of the gain region 1-11A of the light-emitting unit 1-11 is in the slow axis direction matches the fundamental mode spot radius $\omega_0$, and thus a large mode field distribution matching the gain region is formed on the semiconductor chip 1-1. On the other hand, the laser resonant cavity is further configured to adjust the laser emitted by the plurality of semiconductor chips 1-1 to perform spectral synthesis in the fast axis direction.

In a preferred embodiment, the size of the gain region 1-11A of the light-emitting unit 1-11 in the slow axis direction matches the fundamental mode spot radius $\omega_0$ such that: a ratio of a length of laser emitted by a single light-emitting unit 1-11 in the slow axis direction to a projection value of a fundamental mode spot diameter $2\omega_0$ in the slow axis direction of the gain region 1-11A is 1-4.

The semiconductor laser also includes a fast-axis collimating element FAC, which is disposed at a distance $f_{FAC}$ in front of the front end face of the light-emitting unit 1-11, and is configured to collimate the laser emitted by the light-emitting unit 1-11 in the fast axis direction.

Further, the fast-axis collimating element FAC is a short-focal-length cylindrical lens, which is disposed in the laser resonant cavity at the front end of the gain region 1-11A, and focuses in the fast axis direction of the gain region 1-11A with a focal length $f_{FAC}$ of 0.3-1.5mm and a focal length of $\infty$ in the slow axis direction of the gain region 1-11A.

Specifically, the above-mentioned semiconductor gain module 1 includes N semiconductor chips 1-1. The N semiconductor chips 1-1 are vertically disposed in the fast axis direction and parallel to each other in the slow axis direction. Preferably, the N semiconductor chips 1-1 are arranged at equal intervals.

More specifically, each semiconductor chip 1-1 includes M light-emitting units 1-11, $M \geqq 2$, with a ridge width of 2-5 mm. The laser resonant cavity is an unstable cavity in the slow axis direction.

Preferably, the M light-emitting units 1-11 are arranged in series in the slow axis direction. Further preferably, the M light-emitting units are arranged at equal intervals.

The structure of the laser resonant cavity will be described in detail below.

The laser resonant cavity includes a fifth cavity mirror 10, a sixth cavity mirror 11, a fourth output coupling mirror 12, a roof prism 4, a cylindrical conversion lens F, and a diffractive optical element DOE.

The fifth cavity mirror is configured to reflect laser incident on a surface thereof to the semiconductor chip 1-1; a hole is disposed in the center of the fourth output coupling mirror 12, and the fourth output coupling mirror 12 reflects and outputs the laser incident on a surface thereof; and the sixth cavity mirror 11 is configured to reflect the laser passing through the hole to the gain region of the semiconductor chip 1-1.

Specifically, the fifth cavity mirror 10 is a concave mirror with a concave surface facing the light-emitting unit 1-11 and is disposed in front of the fast-axis collimating element FAC; the fourth output coupling mirror 12 is disposed in front of the fast-axis collimating element FAC and has a certain angle $\alpha$ with an optical path in the laser resonant cavity; and the sixth cavity mirror 11 is a concave mirror and is disposed in front of the fourth output coupling mirror 12.

The roof prism 4 is disposed in front of the fast-axis collimating element FAC, and is configured to reflect the laser in the laser resonant cavity to the gain region 1-11A for being output through the fourth output coupling mirror 12.

Preferably, there are M-1 roof prisms 4. The M-1 roof prisms can also be made into one roof prism (for example, M-1 roof prisms are bonded together to be one roof prism).

The cylindrical conversion lens F is provided with a certain focal length f in the fast axis direction and a focal length of $\infty$ in the slow axis direction;

The gain regions 1-11A and the diffractive optical element (DOE) are respectively disposed on two focal points of the cylindrical conversion lens F.

In a preferred embodiment, the concave surfaces of the fifth cavity mirror 10 and the sixth cavity mirror 11 are plated with a film having a high reflectivity; the fourth output coupling mirror 12 is plated with a highly reflective film for a laser angle of $(90-\alpha)$; the front end surface of the semiconductor chip 1-1 is plated with a film having a high transmittance for the output laser wavelength, and the rear end surface thereof is plated with a film having a high reflectivity for the output laser wavelength.

In a preferred embodiment, the semiconductor laser further includes a heat sink 13. The heat sink 13 is disposed below the semiconductor chip 1-1 to dissipate heat from the semiconductor chip 1-1.

It should be noted that the laser oscillation in the slow axis direction of the semiconductor laser according to the eighth embodiment of the present invention is similar to that in the fourth embodiment, and the laser oscillation in the fast axis direction is similar to that in the seventh embodiment.

The semiconductor laser according to the eighth embodiment of the present invention has the following advantages:

(1) In the semiconductor laser according to the eighth embodiment of the present invention, the length of the gain region of the semiconductor laser in the slow axis direction is set to 1 mm-10 cm, and a laser resonant cavity is provided to adjust the semiconductor laser emitted by the light-emitting unit to resonance in the slow axis direction, so that the size of the fundamental mode spot in the slow axis direction matches the length of the gain region of the light-emitting unit in the slow axis direction. On the one hand, it can improve the high-power output capability of the gain region, and on the other hand, it can improve the beam quality and achieve high beam quality output with $M^2 < 2$.

(2) The semiconductor laser according to the eighth embodiment of the present invention has M light-emitting units disposed on the semiconductor chip, and the output power can be increased by M times compared with a semiconductor chip for which one light-emitting unit is provided on one semiconductor chip.

(3) The semiconductor laser according to the eighth embodiment of the present invention is provided with N chips in the fast axis direction, and the laser emitted by the N chips is spectrally combined in the fast axis direction through the laser resonant cavity, which can improve the output of the gain module. Compared with a semiconductor laser with one chip, the output power of the gain module can be increased by N times.

It should be understood that the foregoing specific implementations of the present invention are only intended to exemplarily illustrate or explain the principle of the present invention, and do not constitute a limitation to the present invention. Therefore, any modification, equivalent replacement, improvement, etc. made without departing from the spirit and scope of the present invention should be included in the protection scope of the present invention. Further, the appended claims of the present invention are intended to cover all changes and modifications that fall within the scope and boundary of the appended claims, or equivalents of such ranges and boundaries.

## Claims

1.  A semiconductor laser, comprising:

    one or more semiconductor chips (1-1), a total length of a gain region (1-11A) of a light-emitting unit (1-11) of each of the semiconductor chips (1-1) in a slow axis direction being 1 mm-10 cm;
    a laser resonant cavity configured to adjust semiconductor laser emitted by the light-emitting unit (1-11) to resonate, so that the size of the gain region (1-11A) of the light-emitting unit (1-11) in the slow axis direction matches a fundamental mode spot radius $\omega_0$; and
    a fast-axis collimating element (FAC) disposed in the laser resonant cavity and configured to collimate the laser emitted by the light-emitting unit (1-11) in a fast axis direction.

2.  The semiconductor laser according to claim 1, wherein the size of the gain region (1-11A) of the light-emitting units (1-11) in the slow axis direction matches the fundamental mode spot radius $\omega_0$ such that:
    a ratio of a length of light emitted by a single light-emitting unit (1-11) in the slow axis direction to a projection value of a fundamental mode spot diameter $2\omega_0$ in the slow axis direction of the gain region (1-11A) is 1-4.

3.  The semiconductor laser according to claim 1, wherein a fast-axis collimating element (FAC) is disposed at a distance $f_{FAC}$ from a front end surface of the light-emitting unit (1-11) with a focal length of $f_{FAC}$ in the fast axis direction of the gain region (1-11A) and a focal length of $\infty$ in the slow axis direction of the gain region (1-11A).

4.  The semiconductor laser according to any one of claims 1 to 3, wherein a ridge width of the light-emitting unit of the semiconductor chip is 1-2 mm; and the laser resonant cavity is a stable cavity in the slow axis direction.

5.  The semiconductor laser according to claim 4, wherein the laser resonant cavity comprises a first cavity mirror (2) and a first output coupling mirror (3); and
    the first cavity mirror (2) is configured to reflect laser incident on a surface thereof to the semiconductor chip (1-1) for being output through the first output coupling mirror (3).

6.  The semiconductor laser according to claim 5, wherein the first cavity mirror (2) is a concave mirror with a concave surface facing the light-emitting unit (1-11).

7.  The semiconductor laser according to claim 5 or 6, wherein the semiconductor chip is provided with M light-emitting units (1-11), M≥2, the M light-emitting units (1-11) are connected in series in the slow axis direction, and the M light-emitting units (1-11) are preferably arranged at equal intervals.

8.  The semiconductor laser according to claim 7, wherein the laser resonant cavity further comprises a roof prism (4), and preferably M-1 roof prisms (4); and
    the roof prism (4) is disposed in front of the fast-axis collimating element (FAC), and is configured to reflect the laser in the laser resonant cavity to the gain region (1-11A) until being output by the first output coupling mirror (3).

9.  The semiconductor laser according to any one of claims 5 to 8, wherein:

the first cavity mirror (2) is plated with a film having a high reflectivity for output laser wavelength;

the first output coupling mirror (3) is plated with a partially transmissive film for the output laser wavelength with a transmittance higher than 40%;

the front end surface of the semiconductor chip (1-1) is plated with a film having a high transmittance for the output laser wavelength, and the rear end surface thereof is plated with a film having a high reflectivity for the output laser wavelength; and

a light transmitting surface of the fast-axis collimating element (FAC) is plated with a film having a high transmittance for the output laser.

10. The semiconductor laser according to any one of claims 1 to 3, wherein a ridge width of the light-emitting unit (1-11) of the semiconductor chip (1-1) is 2-5 mm; and the laser resonant cavity is an unstable cavity in the slow axis direction.

11. The semiconductor laser according to claim 10, wherein the laser resonant cavity comprises a second cavity mirror (5), a third cavity mirror (6), and a second output coupling mirror (7);

the second cavity mirror (5) is configured to reflect laser incident on a surface thereof to the semiconductor chip (1-1);

the second output coupling mirror (7), disposed with a hole in the center thereof, reflects and outputs laser incident on a surface thereof; and

the third cavity mirror (6) is configured to reflect the laser passing through the hole to the semiconductor chip (1-1).

12. The semiconductor laser according to claim 11, wherein:

the second cavity mirror (5) is a concave mirror with a concave surface facing the light-emitting unit (1-11), and is disposed in front of the fast-axis collimating element (FAC);

the second output coupling mirror (7) is disposed in front of the fast-axis collimating element (FAC) and has a certain angle $\alpha$ with an optical path in the laser resonant cavity; and

the third cavity mirror (6) is a concave mirror, and is disposed in front of the second output coupling mirror (7).

13. The semiconductor laser according to claim 11 or 12, wherein there are M light-emitting units (1-11), M$\geq$2, the M light-emitting units (1-11) are connected in series in the slow axis direction, and the M light-emitting units are preferably arranged at equal intervals.

14. The semiconductor laser according to claim 13, wherein

the laser resonant cavity further comprises a roof prism (4), and preferably M-1 roof prisms (4); and

the roof prism (4) is disposed in front of the fast-axis collimating element (FAC), and is configured to reflect the laser in the laser resonant cavity to the gain region (1-11A) for being output through the second output coupling mirror (7).

15. The semiconductor laser according to any one of claims 12 to 14, wherein the concave surfaces of the second cavity mirror (5) and the third cavity mirror (6) are plated with a film having a high reflectivity;

the second output coupling mirror (7) is plated with a highly reflective film for a laser angle of (90-$\alpha$);

the front end surface of the semiconductor chip (1-1) is plated with a film having a high transmittance for the output laser wavelength, and the rear end surface thereof is plated with a film having a high reflectivity for the output laser wavelength; and

a light transmitting surface of the fast-axis collimating element (FAC) is plated with a film having a high transmittance for the output laser.

16. The semiconductor laser according to any one of claims 1-3, wherein the plurality of semiconductor chips (1-1) are arranged vertically in the fast axis direction and parallel to each other in the slow axis direction, and the plurality of semiconductor chips (1-1) are preferably arranged at equal intervals.

17. The semiconductor laser according to claim 16, wherein a ridge width of the light-emitting unit (1-11) of the plurality of semiconductor chips (1-1) is 1-2 mm; and the laser resonant cavity is a stable cavity in the slow axis direction.

18. The semiconductor laser according to claim 17, wherein the laser resonant cavity comprises a fourth cavity mirror (8) and a third output coupling mirror (9); and

the fourth cavity mirror (8) is configured to reflect laser incident on a surface thereof to the semiconductor chip (1-1) for being output through the third output coupling mirror (9).

19. The semiconductor laser according to claim 18, wherein the fourth cavity mirror (8) is a concave mirror with a concave surface facing the light-emitting unit (1-11).

20. The semiconductor laser according to claim 18 or 19, wherein the semiconductor chip (1-1) comprises M light-emitting units (1-11), M≥2, the M light-emitting units (1-11) are connected in series in the slow axis direction, and the M light-emitting units are preferably arranged at equal intervals.

21. The semiconductor laser according to claim 20, wherein the laser resonant cavity further comprises a roof prism (4), and preferably M-1 roof prisms (4); and
the roof prism (4) is disposed in front of the fast-axis collimating element (FAC), and is configured to reflect the laser in the laser resonant cavity to the gain region (1-11A) until being output by the third output coupling mirror (9).

22. The semiconductor laser according to any one of claims 18 to 21, wherein
the concave surface of the fourth cavity mirror (8) is plated with a film having a high reflectivity for output laser wavelength;
the third output coupling mirror (9) is plated with a partially transmissive film for the output laser wavelength with a transmittance higher than 40%;
the front end surface of the semiconductor chip (1-1) is plated with a film having a high transmittance for the output laser wavelength, and the rear end surface thereof is plated with a film having a high reflectivity for the output laser wavelength; and
a light transmitting surface of the fast-axis collimating element (FAC) is plated with a film having a high transmittance for output laser.

23. The semiconductor laser according to claim 16, wherein a ridge width of the light-emitting unit (1-11) of each semiconductor chip (1-1) in the plurality of semiconductor chips (1-1) is 2 - 5mm; and the laser resonant cavity is an unstable cavity in the slow axis direction.

24. The semiconductor laser according to claim 23, wherein the laser resonant cavity comprises a fifth cavity mirror (10), a sixth cavity mirror (11), and a fourth output coupling mirror (12);
the fifth cavity mirror is configured to reflect laser incident on a surface thereof to the semiconductor chip (1-1);
the fourth output coupling mirror (12), disposed with a hole in the center thereof, reflects and outputs laser incident on a surface thereof; and
the sixth cavity mirror (11) is configured to reflect the laser passing through the hole to the semiconductor chip (1-1).

25. The semiconductor laser according to claim 24, wherein
the fifth cavity mirror (10) is a concave mirror with a concave surface facing the light-emitting unit (1-11) and is disposed in front of the fast-axis collimating element (FAC);
the fourth output coupling mirror (12) is disposed in front of the fast-axis collimating element (FAC), and is disposed between the fifth cavity mirror (10) and the sixth cavity mirror (11) and has a certain angle with an optical path in the laser resonant cavity; and
the sixth cavity mirror (11) is a concave mirror and is disposed in front of the second output coupling mirror (7).

26. The semiconductor laser according to claim 24 or 25, wherein there are M light-emitting units (1-11), M≥2, the M light-emitting units (1-11) are arranged in series in the slow axis direction, and the M light-emitting units are preferably arranged at equal intervals.

27. The semiconductor laser according to claim 26, wherein the laser resonant cavity further comprises a roof prism (4), and preferably M-1 roof prisms (4); and
the roof prism (4) is disposed in front of the fast-axis collimating element (FAC), and is configured to reflect the laser in the laser resonant cavity to the gain region (1-11A) for being output through the fourth output coupling mirror (12).

28. The semiconductor laser according to any one of claims 24-27, wherein
the concave surfaces of the fifth cavity mirror (10) and the sixth cavity mirror (11) are plated with a film having a high reflectivity;
the fourth output coupling mirror (12) is plated with a highly reflective film for a laser angle of $(90-\alpha)$;
the front end surface of the semiconductor chip (1-1) is plated with a film having a high transmittance for the output laser wavelength, and the rear end surface thereof is plated with a film having a high reflectivity for the output laser wavelength; and
a light transmitting surface of the fast-axis collimating element (FAC) is plated with a film having a high transmittance for output laser.

29. The semiconductor laser according to any one of claims 16 to 28, wherein
the laser resonant cavity is further configured to adjust the laser emitted by the plurality of semiconductor chips (1-1) to perform spectral synthesis in the fast axis direction.

30. The semiconductor laser according to claim 29, wherein
the laser resonant cavity further comprises a cylindrical conversion lens (F) and a diffractive optical element (DOE);
the cylindrical conversion lens (F) is provided with a certain focal length f in the fast axis direction and a focal length of ∞ in the slow axis direction; and
the gain region (1-11A) and the diffractive optical element (DOE) are respectively disposed on two focal points of the cylindrical conversion lens (F).

31. The semiconductor laser according to any one of claims 1-30, further comprising a heat sink (13), the heat sink (13) being disposed below the semiconductor chip (1-1) for dissipating heat from the semiconductor chip (1-1).

$$w\left(\frac{Lcavx}{2}, \frac{Lcavx}{2}, \frac{Lcavx}{2}, R1, R2, 200\right)$$

FIG. 1

**FIG. 2a**

**FIG. 2b**

**FIG. 2c**

**FIG. 3a**

**FIG. 3b**

1–11B
1–11C
1 ~ 2mm
......
1–11A

13    13    13    13

**FIG. 3c**

FAC
5
1
1–1
7
6

**FIG. 4a**

FAC
2 ~ 4mm

**FIG. 4b**

**FIG. 4c**

**FIG. 4d**

**FIG. 4e**

**FIG. 5a**

FIG. 5b

**FIG. 6a**

**FIG. 6b**

**FIG. 7a**

**FIG. 7b**

**FIG. 8a**

**FIG. 8b**

**FIG. 9a**

FIG. 9b

## INTERNATIONAL SEARCH REPORT

| International application No. |
| --- |
| **PCT/CN2019/108481** |

| A. | CLASSIFICATION OF SUBJECT MATTER |
| --- | --- |
| | H01S 5/14(2006.01)i;  H01S 3/082(2006.01)i |

According to International Patent Classification (IPC) or to both national classification and IPC

| B. | FIELDS SEARCHED |
| --- | --- |

Minimum documentation searched (classification system followed by classification symbols)

    H01S

Documentation searched other than minimum documentation to the extent that such documents are included in the fields searched

Electronic data base consulted during the international search (name of data base and, where practicable, search terms used)

    VEN; CNABS; CNTXT; CNKI: 反射镜, 第二, 增益介质, 输出镜, 基模, 工作物质, 镜, 腔长, 光斑, 腔镜, 半导体, 全反镜, 高反镜, 慢轴, 半导体, 输出耦合镜, 两, 输出, OUTPUT, fundamental mode, basic mode, mirror, reflect+, cavity, slow axis, spot

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 109193342 A (TECHNICAL INSTITUTE OF PHYSICS AND CHEMISTRY, CAS) 11 January 2019 (2019-01-11)<br>    claims 1-31 | 1-31 |
| A | EP 0955707 A2 (FUJI PHOTO FILM CO., LTD.) 10 November 1999 (1999-11-10)<br>    description, paragraphs [0001]-[0073], and figures 1-10C | 1-31 |
| A | CN 1879269 A (OSRAM OPTO SEMICONDUCTORS GMBH) 13 December 2006 (2006-12-13)<br>    entire document | 1-31 |
| A | CN 102082396 A (JIANGNAN UNIVERSITY) 01 June 2011 (2011-06-01)<br>    entire document | 1-31 |
| A | WO 0159895 A1 (GIGATERA AG et al.) 16 August 2001 (2001-08-16)<br>    entire document | 1-31 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **02 December 2019** | **06 January 2020** |

| Name and mailing address of the ISA/CN | Authorized officer |
| --- | --- |
| **China National Intellectual Property Administration**<br>**No. 6, Xitucheng Road, Jimenqiao Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2019/108481**

| Patent document cited in search report | | | Publication date (day/month/year) | Patent family member(s) | | | Publication date (day/month/year) |
|---|---|---|---|---|---|---|---|
| CN | 109193342 | A | 11 January 2019 | None | | | |
| EP | 0955707 | A2 | 10 November 1999 | DE | 69937857 | D1 | 14 February 2008 |
| | | | | EP | 0955707 | B1 | 02 January 2008 |
| | | | | JP | 3387824 | B2 | 17 March 2003 |
| | | | | JP | H11317562 | A | 16 November 1999 |
| | | | | US | 6163558 | A | 19 December 2000 |
| | | | | EP | 0955707 | A3 | 12 April 2006 |
| | | | | DE | 69937857 | T2 | 02 January 2009 |
| CN | 1879269 | A | 13 December 2006 | WO | 2005048423 | A1 | 26 May 2005 |
| | | | | EP | 1683244 | B1 | 10 September 2008 |
| | | | | TW | I244815 | B | 01 December 2005 |
| | | | | KR | 20060123319 | A | 01 December 2006 |
| | | | | TW | 200522459 | A | 01 July 2005 |
| | | | | CN | 100508310 | C | 01 July 2009 |
| | | | | US | 2007201531 | A1 | 30 August 2007 |
| | | | | DE | 502004008051 | D1 | 23 October 2008 |
| | | | | JP | 2007511081 | A | 26 April 2007 |
| | | | | KR | 101186927 | B1 | 28 September 2012 |
| | | | | EP | 1683244 | A1 | 26 July 2006 |
| | | | | DE | 112004002026 | D2 | 29 June 2006 |
| | | | | US | 7408972 | B2 | 05 August 2008 |
| CN | 102082396 | A | 01 June 2011 | None | | | |
| WO | 0159895 | A1 | 16 August 2001 | DE | 60120651 | T2 | 31 May 2007 |
| | | | | AT | 330347 | T | 15 July 2006 |
| | | | | US | 6735234 | B1 | 11 May 2004 |
| | | | | JP | 2003523092 | A | 29 July 2003 |
| | | | | EP | 1264373 | A1 | 11 December 2002 |
| | | | | AU | 2994401 | A | 20 August 2001 |
| | | | | CA | 2399661 | A1 | 16 August 2001 |
| | | | | JP | 4977298 | B2 | 18 July 2012 |
| | | | | IL | 150788 | D0 | 12 February 2003 |
| | | | | DE | 60120651 | D1 | 27 July 2006 |
| | | | | EP | 1264373 | B1 | 14 June 2006 |

Form PCT/ISA/210 (patent family annex) (January 2015)